# EUROPÄISCHE PATENTANMELDUNG

(11) **EP 1 319 984 A2**
(43) Veröffentlichungstag der Anmeldung: **18.06.2003**
(21) Anmeldenummer: 02027118.5
(22) Anmeldetag: 04.12.2002
(51) Int. Cl.: G03F 7/20

(54) **Lithographiebelichtungseinrichtung**

(30) Priorität: 07.12.2001 DE 10160917
(71) Anmelder: KLEO Halbleitertechnik GmbH & Co KG, 88069 Tettnang (DE)
(72) Erfinder: Opower, Hans, 82152 Krailling (DE); Scharl, Stefan, 88142 Wasserburg (DE)
(74) Vertreter: Hoeger, Stellrecht & Partner

(57) **Zusammenfassung**

Um eine Lithografiebelichtungseinrichtung zum Herstellen von belichteten Strukturen in einer lichtempfindlichen Schicht, mit einer Belichtungseinheit mit einer Bewegungseinheit zur Relativbewegung zwischen der Fokussierungsoptik und einer Aufnahme und mit einer Steuerung zur Steuerung von Intensität und Lage der Belichtungsflecken derart, daß mittels der Belichtungsflecken eine Vielzahl von Umwandlungsbereichen in der lichtempfindlichen Schicht erzeugbar ist, zu schaffen, bei welcher mit einer reduzierten Zahl von Laserstrahlungsquellen gearbeitet werden kann, wird vorgeschlagen, daß mit dem Belichtungsfleck jeder Laserstrahlungsquelle innerhalb eines Streifenbereichs, welcher eine ein Mehrfaches der Ausdehnung des Belichtungsflecks betragende Breite aufweist, sämtliche innerhalb desselben liegende Umwandlungsbereiche durch Bewegen des Belichtungsflecks in einer quer zur Belichtungsbewegungsrichtung verlaufenden Ablenkrichtung erzeugbar sind und daß zum Bewegen des Belichtungsflecks in der Ablenkrichtung zwischen den Laserstrahlungsquellen und der Fokussierungsoptik eine steuerbare Ablenkeinrichtung vorgesehen ist.

## Beschreibung

Die Erfindung betrifft eine Lithografiebelichtungseinrichtung zum Herstellen von sich in einer Fläche erstreckenden belichteten Strukturen in einer lichtempfindlichen Schicht, mit einer Aufnahme für die lichtempfindliche Schicht, mit einer Belichtungseinheit umfassend mehrere Laserstrahlungsquellen, eine den Laserstrahlungsquellen zugeordnete Fokussierungsoptik für die aus den jeweiligen Laserstrahlungsquellen ausdrehende Laserstrahlung, welche aus der Laserstrahlung jeder der Laserstrahlungsquellen einen in der lichtempfindlichen Schicht wirksamen Belichtungsfleck mit einer festgelegten Ausdehnung quer zu einer Belichtungsbewegungsrichtung erzeugt, mit einer Bewegungseinheit zur Erzeugung einer Relativbewegung zwischen der Fokussierungsoptik und der Aufnahme in der Belichtungsbewegungsrichtung und mit einer Steuerung von Intensität und Lage der Belichtungsflecken relativ zur lichtempfindlichen Schicht derart, daß mittels der Belichtungsflecken eine Vielzahl von Umwandlungsbereichen in der lichtempfindlichen Schicht erzeugbar ist, in denen das Material der lichtempfindlichen Schicht von einem Ausgangszustand in einen belichteten Zustand umgewandelt ist und die zusammen die belichtete Struktur ergeben.

Derartige Lithografiebelichtungseinrichtungen sind aus der WO 98/00760 bekannt.

Bei diesen Lithografiebelichtungseinrichtungen besteht das Problem, daß eine große Zahl von Belichtungsflecken erforderlich ist, um in einer festgelegten Fläche mit der notwendigen Präzision eine belichtete Struktur zu erzeugen, da die maximal mögliche Ausdehnung der belichteten Struktur quer zur Belichtungsbewegungsrichtung durch einander überlappende Belichtungsflecken realisiert werden muß.

Dies hat zur Folge, daß - wenn man davon ausgeht, daß für jeden Belichtungsfleck eine Laserstrahlungsquelle erforderlich ist - eine Vielzahl von Laserstrahlungsquellen eingesetzt werden muß.

Der Erfindung liegt daher die Aufgabe zugrunde, eine Lithografiebelichtungseinrichtung der eingangs beschriebenen Art zu schaffen, bei welcher mit einer reduzierten Zahl von Laserstrahlungsquellen gearbeitet werden kann.

Diese Aufgabe wird bei einer Lithografiebelichtungseinrichtung der eingangs beschriebenen Art erfindungsgemäß dadurch gelöst, daß mit dem Belichtungsfleck jeder der Laserstrahlungsquellen innerhalb eines sich in der Belichtungsbewegungsrichtung erstreckenden Streifenbereichs, welcher quer zu der Belichtungsbewegungsrichtung eine ein mehrfaches der Ausdehnung des Belichtungsflecks in dieser Richtung betragende Breite aufweist, sämtliche innerhalb desselben liegende Umwandlungsbereiche durch Bewegen des Belichtungsflecks in eine quer zur Belichtungsbewegungsrichtung verlaufenden Ablenkrichtung erzeugbar sind und daß zum Bewegen des Belichtungsflecks in der Ablenkrichtung zwischen den Laserstrahlungsquellen und der Fokussierungsoptik eine steuerbare Ablenkeinrichtung vorgesehen ist.

Der Vorteil der erfindungsgemäßen Lösung ist somit darin zu sehen, daß durch die vorgesehenen Streifenbereiche, innerhalb welcher mit einem einzigen Belichtungsfleck sämtliche Umwandlungsbereiche erzeugbar sind, die Möglichkeit geschaffen wurde, die Zahl der Laserstrahlungsquellen zu reduzieren.

Ferner schafft die Möglichkeit, den Belichtungsfleck in der Ablenkrichtung zu bewegen, die Möglichkeit, die Präzision im Bereich der Ränder der belichteten Struktur, d.h. die sogenannte Randwelligkeit zu verbessern.

Hinsichtlich des Prinzips der Strahlablenkung, das in der Ablenkeinrichtung eingesetzt werden soll, sind die unterschiedlichsten Lösungen denkbar.

Beispielsweise wären mechanische Ablenkungen oder piezoelektrisch arbeitende Ablenkeinrichtungen denkbar.

Zum Erreichen einer möglichst schnellen und möglichst präzisen Ablenkung der Laserstrahlung hat es sich jedoch als besonders vorteilhaft erwiesen, wenn die Ablenkeinrichtung elektrooptisch arbeitet.

Grundsätzlich wäre es denkbar, die den Laserstrahlungsquellen zugeordneten Streifenbereiche im Abstand voneinander zu legen und nach einem Durchlauf in der Belichtungsbewegungsrichtung mit einem erneuten Durchlauf in den Zwischenräumen zwischen den Streifenbereichen zu belichten. Dies hätte bei einer vorgegebenen Fläche den weiteren Vorteil, daß sich noch weitere Laserstrahlungsquellen einsparen ließen, jedoch den Nachteil einer nicht mehr zufriedenstellenden Präzision.

Aus diesem Grund ist vorteilhafterweise vorgesehen, daß die den Laserstrahlungsquellen zugeordneten Streifenbereiche unmittelbar nebeneinander liegen und somit quer zur Belichtungsbewegungsrichtung einen vorgegebenen und mit einer Belichtungsbewegung zu belichtenden Flächenbereich vollständig überdecken.

Um jedoch an den Rändern der Streifenbereiche mit den diesen jeweils zugeordneten Belichtungsflecken zusammenhängende Umwandlungsbereiche mit durchgehender Umwandlung des Materials der lichtempfindlichen Schicht in den belichteten Zustand erzeugen zu können, ist vorteilhafterweise vorgesehen, daß die nebeneinander liegenden Streifenbereiche sich quer zur Belichtungsbewegungsrichtung überlappen.

Prinzipiell wäre es ebenfalls denkbar, auch in Belichtungsbewegungsrichtung mehrere Streifenbereiche aneinander zu setzten.

Besonders günstig ist es jedoch, wenn die Streifenbereiche sich in Belichtungsbewegungsrichtung über die gesamte lichtempfindliche Schicht erstrecken, so daß beim Erzeugen der belichteten Struktur in Belichtungsbewegungsrichtung ein Belichten über die gesamte lichtempfindliche Schicht erfolgt.

Die Ablenkeinrichtung könnte im Rahmen der erfindungsgemäßen Lösung unterschiedlich ausgebildet sein. Beispielsweise wäre es denkbar, die Ablenkeinrichtung insgesamt anzusteuern und dabei allerdings lediglich diejenigen Laserstrahlungsquellen zu aktivieren, deren Laserstrahlung zum jeweiligen Zeitpunkt gerade in dem Maß abgelenkt werden muß, das die Ablenkeinrichtung zum jeweiligen Zeitpunkt aufweist.

Um jedoch eine möglichst große Belichtungsleistung zu erreichen, hat es sich als vorteilhaft erwiesen, wenn die Ablenkeinrichtung für die Laserstrahlung jeder Laserstrahlungsquelle eine eigene Ablenkeinheit aufweist, mit welcher die Ablenkung der Laserstrahlung in der Ablenkrichtung zur Positionierung des Belichtungsfleck in Ablenkrichtung innerhalb des diesem entsprechenden Streifenbereichs erfolgt.

Diese Lösung hat den Vorteil, daß bei einer Relativbewegung in der Belichtungsbewegungsrichtung zum Erzeugen der belichteten Struktur zu jedem Zeitpunkt stets all diejenigen Laserstrahlungsquellen angesteuert werden können, deren Belichtungsflecken zum jeweiligen Zeitpunkt zu dem zu erzeugenden Umwandlungsbereich beitragen sollen, wobei die Geschwindigkeit bei der Positionierung des Belichtungsflecks in Ablenkrichtung so groß gewählt sein muß, daß beispielsweise eine kontinuierliche Bewegung in Belichtungsbewegungsrichtung keine nennenswerten Verzerrungen bewirkt.

Beispielsweise hat dies zur Folge, daß die Bewegung eines der Belichtungsflecken in Ablenkrichtung innerhalb des diesem zugeordneten Streifenbereichs innerhalb eines Zeitraums von weniger als 10 ns erfolgen sollte, sofern die Geschwindigkeit in Belichtungsbewegungsrichtung 1m/s beträgt, wobei die Breite des Streifenbereichs beispielsweise etwa dem zehnfachen der Ausdehnung des Lichtflecks in Ablenkrichtung entsprechen sollte.

Prinzipiell wäre es denkbar, eine gerasterte Positionierung des Lichtflecks innerhalb des Streifenbereichs vorzusehen, wobei die gerasterte Positionierung des Lichtflecks so zu sein hätte, daß der von dem Belichtungsfleck in einer Rasterposition erzeugte Umwandlungsbereich zumindest mit dem Belichtungsfleck in der benachbarten Rasterposition überlappt.

Noch einfacher ist es jedoch, wenn mit der Ablenkeinheit der Belichtungsfleck in der Ablenkrichtung beliebig innerhalb des Streifenbereichs positionierbar ist.

Vorzugsweise ist daher jede der Ablenkeinheiten der Ablenkeinrichtung einzeln durch die Steuerung steuerbar.

Hinsichtlich der Anordnung der Ablenkeinheiten selbst wurden bislang keine nähren Angeben gemacht. So wäre es prinzipiell denkbar, die Ablenkeinheiten nebeneinander in einer Ebene anzuordnen, die parallel zu den untereinander parallel verlaufenden Ablenkrichtungen der Ablenkeinheiten verläuft.

Dadurch könnte jedoch das Problem auftreten, daß sich die bauliche Konzeption der einzelnen Ablenkeinheiten untereinander aufgrund des geringen Abstandes der Ablenkeinheiten nur aufwendig realisieren ließe.

Aus diesem Grund sieht eine besonders vorteilhafte Ausführungsform der erfindungsgemäßen Lithografiebelichtungseinrichtung vor, daß die Ablenkeinheiten in mehreren in der Belichtungsbewegungsrichtung aufeinander folgenden Ebenen angeordnet sind.

Besonders günstig ist es dabei, daß bei einer Folge von in Ablenkrichtung aufeinander folgenden Streifenbereichen die Ablenkeinheiten von in der Folge von Streifenbereichen einander benachbarten Streifenbereichen in unterschiedlichen Ebenen liegen.

Durch das Verlegen der Ablenkeinrichtungen, die benachbarten Streifenbereichen zugeordnet sind, in unterschiedliche Ebenen läßt sich die erfindungsgemäße Ablenkeinrichtung konstruktiv einfacher und somit auch kostengünstiger herstellen.

Besonders günstig ist es dabei, daß bei der Folge von aufeinanderfolgenden Streifenbereichen die Ablenkeinheiten in derselben Ebene liegen, die den Streifenbereichen zugeordnet sind, die in der Folge von Streifenbereichen durch mindestens einen dazwischen liegenden Streifenbereich voneinander getrennt sind.

Eine weitere besonders günstig realisierbare Lösung sieht vor, daß in jeder der in Belichtungsbewegungsrichtung aufeinander folgenden Ebenen die Ablenkeinheiten für die Streifenbereiche liegen, die in der Folge der Streifenbereiche um eine der Zahl der Ebenen entsprechende Platzzahl auseinander liegen.

Das heißt, daß bei zwei Ebenen jeweils dem übernächsten Streifenbereich zugeordneten Ablenkeinheiten in einer Ebene liegen und bei drei Ebenen jeweils die überübernächsten Streifenbereichen zugeordneten Ablenkeinheiten in ein und derselben Ebene liegen.

Im Zusammenhang mit der bisherigen Erläuterung der einzelnen Ausführungsbeispiele wurde nicht mehr darauf eingegangen, wie die einzelnen Ablenkeinheiten aufgebaut sein sollen.

So hat es sich als besonders günstig erwiesen, wenn jede elektrooptische Ablenkeinheit mindestens einen von der Laserstrahlung durchsetzten strahlablenkenden Raumbereich aus elektrooptischem Material aufweist, in welchem die Brechzahl gegenüber der Brechzahl in dessen Umgebung elektrooptisch variabel ist und daß bei einer von der Brechzahl der Umgebung abweichenden Brechzahl in dem mindestens einen Raumbereich die Summe der Raumbereiche der Ablenkeinheit die Laserstrahlung in einer gegenüber einer ursprünglichen Richtung geändert verlaufenden Austrittsrichtung aus der Ablenkeinheit austreten läßt.

Der Vorteil dieser Lösung ist darin zu sehen, daß sich durch die variable Einstellung der Brechzahl in dem mindestens einen Raumbereich die Ablenkung der Laserstrahlung variabel einstellen läßt und somit die Möglichkeit besteht, die Abweichung des Verlaufs der Austrittsrichtung und der ursprünglichen Richtung durch die Einstellung der Brechzahl zu variieren, wobei eine stufenförmige oder eine stufenlose Einstellung der Brechzahl möglich ist und somit auch eine stufenförmige oder eine stufenlose Variation des veränderten Verlaufs der Austrittsrichtung gegenüber der ursprünglichen Richtung möglich ist.

Eine besonders günstige Lösung sieht dabei vor, daß der Raumbereich innerhalb einer sich mit ihren Flachseiten parallel zur Ablenkrichtung erstreckenden Wellenleiterplatte aus elektrooptischem Material ausgebildet ist. Das Vorsehen einer derartigen Wellenleiterplatte zur Führung der Laserstrahlung hat den Vorteil, daß damit die Möglichkeit besteht, die Laserstrahlung zumindest in einer Richtung quer zur Ausbreitungsrichtung auf engem Raum zu führen und innerhalb der Wellenleiterplatte eine Divergenz in dieser Richtung zu vermeiden.

Aus Gründen der einfachen Herstellbarkeit einer derartigen Wellenleiterplatte ist es dabei zweckmäßig, wenn die Wellenleiterplatte selbst aus elektrooptischem Material ist und sich über den Raumbereich hinaus erstreckt, so daß das elektrooptische Material der Wellenleiterplatte die Brechzahl in der Umgebung des Raumbereichs und somit die Wirkung des Raumbereichs auf die Laserstrahlung auch von der Differenz der Brechzahl außerhalb des Raumbereichs und der Brechzahl innerhalb des Raumbereichs abhängt.

Um die Brechzahl in dem Raumbereich in einfacher Weise variieren zu können, ist vorzugsweise vorgesehen, daß der Raumbereich zwischen einer ersten und einer zweiten Feldelektrode angeordnet ist, so daß sich über die Feldelektrode die Brechzahl in dem Raumbereich einstellen läßt.

Besonders günstig ist es dabei, wenn die Feldelektroden auf gegenüberliegenden Flachseiten der den Raumbereich umfassenden Wellenleiterplatte angeordnet ist.

Dabei hat die Wellenleiterplatte noch den weiteren Vorteil, daß sie die Möglichkeit schafft, die Feldelektroden in möglichst geringem Abstand voneinander anzuordnen und somit die Felder, die zur Beeinflussung des Brechungsindex in dem elektrooptischen Material erforderlich sind, möglichst klein zu halten.

Besonders günstig ist es dabei, wenn die erste Feldelektrode durch unmittelbar auf die erste Flachseite der Wellenleiterplatte aufgebrachtes Elektrodenmaterial gebildet ist.

Ferner ist es günstig, wenn die zweite Feldelektrode durch unmittelbar auf die zweite Flachseite der Wellenleiterplatte aufgebrachtes Elektrodenmaterial gebildet ist.

Damit ist die Möglichkeit geschaffen, die Feldelektroden mit dem geringst möglichen Abstand voneinander anzuordnen und somit mit möglichst geringen Spannungen zu arbeiten.

Hinsichtlich der Festlegung der Form des Raumbereichs wurden im Zusammenhang mit der bisherigen Erläuterung der Ausführungsformen keine näheren Angaben gemacht. So sind dabei unterschiedlichste Lösungen denkbar.

Eine bevorzugte Ausführung der erfindungsgemäßen Lösung sieht vor, daß eine Form des Raumbereichs durch Festlegung eines räumlichen Verlaufs eines die Wellenleiterplatte durchsetzenden elektrischen Feldes festlegbar ist. Diese Möglichkeit beruht auf dem Effekt, daß sich die Brechzahl in einem elektrooptischen Material durch ein elektrisches Feld verändern läßt, wobei alle die Bereiche des elektrooptischen Materials, die nicht vom elektrischen Feld durchsetzt werden, in der Brechzahl nicht verändert werden.

Damit läßt sich allein durch den Feldverlauf die Form des Raumbereichs festlegen.

Besonders einfach läßt sich der Feldverlauf dann festlegen, wenn das elektrische Feld durch die Form der ersten Feldelektrode definiert ist.

Prinzipiell wäre es dabei denkbar, die zweite Feldelektrode entsprechend der ersten Feldelektrode zu formen. Aus Gründen der Einfachheit ist es, insbesondere bei den geringen, mit einer Wellenleiterplatte realisierbaren Abständen von Vorteil, wenn die zweite Feldelektrode sich über den Raumbereich hinaus erstreckt, so daß diese nicht identisch mit der ersten Feldelektrode geformt sein muß.

Alternativ oder ergänzend dazu sieht ein weiteres Ausführungsbeispiel vor, daß die Form des Raumbereichs durch Festlegung einer räumlichen Form mindestens eines spontan elektrisch polarisierten Domänenbereichs im elektrooptischen Material der Wellenleiterplatte festgelegt ist.

In diesem Fall erübrigt es sich, die Feldelektroden entsprechend dem Raumbereich zu formen, sondern aus Gründen der Einfachheit können die Feldelektroden sich über den Domänenbereich hinaus erstrecken.

Prinzipiell wurde im Zusammenhang mit der Ablenkung der Laserstrahlung in der jeweiligen Ablenkeinheit von mindestens einem Raumbereich ausgegangen. Um die Effizienz der Ablenkung zu steigern oder die Qualität der Ablenkung zu verbessern, ist es von Vorteil, wenn jede Ablenkeinheit mehrere Raumbereiche mit elektrooptisch variabler Brechzahl umfaßt.

Vorzugsweise sind dabei die Raumbereiche in Ausbreitungsrichtung der jeweiligen Laserstrahlung aufeinanderfolgend angeordnet.

Grundsätzlich besteht die Möglichkeit, die mehreren Raumbereiche in unterschiedlichen Wellenleiterplatten anzuordnen. Eine besonders zweckmäßige Lösung sieht jedoch vor, daß die mehreren Raumbereiche in derselben Wellenleiterplatte angeordnet sind.

Eine besonders günstige Lösung sieht außerdem vor, daß die Ablenkeinheit die Laserstrahlung durch zwei entgegengesetzt wirkende Raumbereiche in Ablenkrichtung im Wesentlichen parallel versetzt, so daß dabei insbesondere in der nachfolgenden Fokussierungsoptik keinerlei zusätzliche Deformation der Laserstrahlung erfolgt.

Hinsichtlich der Ausbildung des strahlablenkenden Raumbereichs wurden im Zusammenhang mit der bisherigen Erläuterung der einzelnen Ausführungsformen keine näheren Angaben gemacht.

Prinzipiell könnte eine Vielzahl von strahlablenkenden Raumbereichen vorgesehen sein, die alle einzelne Bereiche der Laserstrahlung einer Laserstrahlungseinheit umlenken, wobei derartige Raumbereiche nicht zusammenhängend in der Wellenleiterplatte angeordnet sein müssen.

Eine besonders einfache Ausführungsform sieht jedoch vor, daß sich der mindestens eine strahlablenkende Raumbereich in Ablenkrichtung keilähnlich erweitert oder vereinigt und von der gesamten Laserstrahlung durchsetzt ist.

Ein derartiger strahlablenkender Raumbereich kann dabei noch ebenfalls die unterschiedlichsten Formen aufweisen. Beispielsweise kann dieser Raumbereich durch quer zur Ausbreitungsrichtung der Laserstrahlung verlaufende ebene, gekrümmte oder auch gestufte Flächen begrenzt sein, wobei durch einen in der Ablenkrichtung keilförmigen Verlauf der zwei quer zur Ausbreitungsrichtung der Laserstrahlung verlaufenden Begrenzungsflächen eine Ablenkung der Laserstrahlung durch Variation des Brechungsindex im Raumbereich realisierbar ist.

Beispielsweise könnte der Raumbereich derartige Begrenzungsflächen aufweisen, daß gleichzeitig zur Ablenkung noch eine Korrektur der Strahldivergenz oder eine spezielle Strahlformung erfolgt.

Eine besonders einfache Lösung sieht jedoch vor, daß der strahlablenkende Raumbereich ähnlich einem Prismenbereich ausgebildet ist. Dabei kann ein Prisma eine Grundform dieses Raumbereichs sein, die zusätzlich noch durch Änderungen, beispielsweise zur Strahlformung variiert sein kann.

Hinsichtlich der Ausbreitung der Laserstrahlung in der Wellenleiterplatte wurden bislang keine näheren Angaben gemacht. So wäre es beispielsweise denkbar, die insbesondere über einen Wellenleiter der Wellenleiterplatte zugeführte Laserstrahlung einfach durch die Wellenleiterplatte zu führen, wobei dadurch eine Strahldivergenz quer zur Ausbreitungsrichtung und parallel zu Flachseiten der Wellenleiterplatte auftreten würde.

Aus diesem Grund ist vorzugsweise vorgesehen, daß sich die Laserstrahlung in der Wellenleiterplatte in Ablenkrichtung aufgeweitet, beispielsweise bandförmig, ausbreitet und somit bereits durch die Aufweitung die Divergenz reduziert werden kann.

Vorzugsweise wird hierzu die Laserstrahlung durch eine Strahlformungseinheit parallel zur Ablenkrichtung aufgeweitet.

Eine derartige Strahlformungseinheit kann entweder separat außerhalb der Wellenleiterplatte angeordnet sein. Besonders vorteilhaft ist es jedoch, wenn die Strahlformungseinheit in die Wellenleiterplatte integriert ist.

Dabei kann die Strahlformungseinheit in unterschiedlichster Art und Weise ausgebildet sein.

Beispielsweise ist es denkbar, die Strahlformungseinheit so auszubilden, daß sie elektrooptisch arbeitet, das heißt, daß durch das Erzeugen eines elektrischen Feldes innerhalb eines Raumbereichs eine Strahlformung realisierbar ist.

Eine andere vorteilhafte Lösung sieht vor, daß die Strahlformungseinheit als GRIN-Linse ausgebildet ist.

Hinsichtlich der Art der Steuerung der Ablenkeinheiten wurden im Zusammenhang mit der bisherigen Erläuterung der einzelnen Ausführungsbeispiele keine näheren Angaben gemacht.

So sieht eine vorteilhafte Ausführungsform vor, daß die Steuerung die Ablenkeinheiten mit einer der erforderlichen Position des Belichtungsflecks innerhalb des jeweiligen Streifenbereichs entsprechenden Spannung ansteuert. Die Spannung kann dabei in unterschiedlichster Weise festgelegt werden.

Eine vorteilhafte Ausführungsform sieht vor, daß die Spannung stufenlos variabel ist. Dies hat zur Konsequenz, daß der Belichtungsfleck an jeder beliebigen Stelle innerhalb des Streifenbereichs positioniert werden kann.

Eine andere Lösung sieht vor, daß die Spannung in diskreten Schritten variabel ist, was zur Folge hat, daß der Belichtungsfleck lediglich entsprechend den diskreten Schritten der Spannung an bestimmten Stellen innerhalb des Streifenbereichs positionierbar ist.

Bei Ablenkeinheiten mit mehreren Raumbereichen sind noch weitere Ansteuerungsmöglichkeiten denkbar.

So sieht eine vorteilhafte Ausführungsform vor, daß bei mehreren Raumbereichen einer Ablenkeinheit die Brechzahl synchron variierbar ist, das heißt, die Ansteuerung der einzelnen Raumbereiche einer Ablenkeinheit synchron erfolgt.

Bei der synchronen Ansteuerung kann dabei nach wie vor die Einstellung der Spannung variabel erfolgen, das heißt mit beliebigen Spannungswerten zwischen dem Minimalwert und dem Maximalwert, es ist aber auch denkbar, die Spannung in diskreten Schritten einzustellen.

Eine alternative Ausführungsform bei Ablenkeinheiten mit mehreren Raumbereichen sieht vor, daß bei den mehreren Raumbereichen einer Ablenkeinheit die Brechzahl einzeln ansteuerbar ist, das heißt, daß jeder Raumbereich einzeln ansteuerbar ist und somit in jedem Raumbereich die Brechzahl einzeln einstellbar ist.

In diesem Fall besteht ebenfalls die Möglichkeit, die Spannung in jedem Raumbereich variabel einstellbar zu gestalten, das heißt zwischen einem Minimalwert und einem Maximalwert mit beliebigen Zwischenwerten, oder diskrete Schritte für die Spannung vorzusehen.

Eine weitere Vereinfachung ergibt sich jedoch bei der einzelnen Ansteuerung der einzelnen Raumbereiche dann, wenn die Raumbereiche mit diskreten Spannungswerten, also beispielsweise in festgelegten Stufen ansteuerbar sind.

Der einfachste Fall der Verwendung diskreter Spannungswerte sieht vor, daß die einzelnen Raumbereiche entweder spannungsfrei oder mit einem festgelegten Spannungswert angesteuert sind. Das heißt, daß in diesem Fall entweder eine Ansteuerung des Raumbereichs erfolgt oder nicht, so daß dessen Ablenkwirkung entweder eingesetzt wird oder nicht.

So lassen sich beispielsweise bei N-Raumbereichen einer Ablenkeinheit N+1 Positionen des Belichtungsflecks festlegen, nämlich eine Position festgelegt durch die Ansteuerung von keinem der Raumbereiche und dann sukzessiv noch zusätzlich N-Positionen durch die sukzessive Ansteuerung jeweils eines zusätzlichen Raumbereichs, so daß bei Ansteuerung aller N-Raumbereiche die maximale Ablenkung erreichbar ist.

Bei allen bislang beschriebenen Arten der Ansteuerung der Ablenkeinheiten wurde nicht näher darauf eingegangen, wie die Ansteuerung der Ablenkeinheiten im Zusammenhang mit der Intensitätssteuerung der Laserstrahlungsquellen erfolgt.

So wäre es beispielsweise bei einer Ausführungsform denkbar, die Ansteuerung der Ablenkeinheiten so auszuführen, daß im Verlauf der Bewegung des Belichtungsflecks in der Belichtungsbewegungsrichtung und in der Ablenkrichtung der Belichtungsfleck innerhalb des Streifenbereichs positioniert und dann, wenn der Belichtungsfleck innerhalb eines Umwandlungsbereichs liegt, durch Intensitätssteuerung der Laserstrahlungsquelle in diesem Belichtungsfleck belichtet wird.

Dabei ist es möglich so lange kontinuierlich zu belichten, solange der Belichtungsfleck in einem Umwandlungsbereich liegt. Alternativ dazu ist es aber auch denkbar, gepulst zu belichten, solang der Belichtungsfleck im Umwandlungsbereich liegt.

Es ist aber auch denkbar, während der Bewegung in der Belichtungsbewegungsrichtung gleichzeitig die Ablenkeinheiten so anzusteuern, daß der Belichtungsfleck beispielsweise entsprechend einer periodischen Funktion ständig in dem Streifenbereich zwischen einer Minimal- und einer Maximalstellung hin- und herbewegt wird und dann, wenn der Belichtungsfleck aufgrund der periodischen Funktion die Position innerhalb des Streifenbereichs in Ablenkrichtung erreicht hat, die erwünscht ist, durch Intensitätssteuerung der Laserstrahlungsquelle eine Belichtung erfolgt.

Diese Lösung hat den Vorteil, daß damit eine stabile Spannungsquelle für die Ablenkeinheiten eingesetzt werden kann und beispielsweise sogar die Möglichkeit besteht, alle Ablenkeinheiten synchron zueinander anzusteuern und bei Erreichen des gewünschten Orts die jeweilige Laserstrahlungsquelle gepulst zu schalten.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Figur 1: einen grundsätzlichen schematischen Aufbau einer erfindungsgemäßen Lithografiebelichtungseinrichtung;
- Figur 2: eine schematische Darstellung von mit der erfindungsgemäßen Lithografiebelichtungseinrichtung herstellbaren belichteten Strukturen und der hierzu eingesetzten Bildflecken;
- Figur 3: eine schematische in Blöcken zusammengefaßte Darstellung des Aufbaus einer erfindungsgemäßen Lithografiebelichtungseinrichtung;
- Figur 4: eine schematische Darstellung einer Wirkungsweise eines Ausführungsbeispiels einer Ablenkeinheit einer erfindungsgemäßen Lithografiebelichtungseinrichtung;
- Figur 5: eine schematische Darstellung eines einer Wirkungsweise einer gegenüber Fig. 4 modifizierten Ablenkeinheit einer erfindungsgemäßen Lithografiebelichtungseinrichtung;
- Figur 6: eine schematische Darstellung einer Realisierung eines ersten Ausführungsbeispiels der erfindungsgemäßen Lithografiebelichtungseinrichtung;
- Figur 7: einen Schnitt längs Linie 7-7 in Figur 6;
- Figur 8: eine schematische Darstellung ähnlich Figur 5 eines zweiten Ausführungsbeispiels einer Ablenkeinheit einer erfindungsgemäßen Lithografiebelichtungseinrichtung;
- Figur 9: einen Schnitt längs Linie 9-9 in Figur 8;
- Figur 10: eine Darstellung ähnlich Figur 5 eines dritten Ausführungsbeispiels einer Ablenkeinheit einer erfindungsgemäßen Lithografiebelichtungseinrichtung;
- Figur 11: eine schematische Darstellung eines ersten Ausführungsbeispiels einer erfindungsgemäßen Strahlformungseinheit;
- Figur 12: einen Schnitt längs Linie 12-12 in Fig. 11;
- Figur 13: eine schematische Darstellung eines zweiten Ausführungsbeispiels einer erfindungsgemäßen Strahlformungseinheit;
- Figur 14: eine schematische Darstellung der Divergenz der aus einer Wellenleiterplatte einer erfindungsgemäßen Ablenkeinheit austretenden Laserstrahlung;
- Figur 15: eine schematische Darstellung einer Strahlformungseinheit zur Formung eines in die Fokussierungsoptik eintretenden Strahlenbündels;
- Figur 16: eine schematische geschnittene Darstellung durch die Anordnung mehrerer Ablenkeinheiten bei der erfindungsgemäßen Lösung;
- Figur 17: eine schematische ausschnittsweise Darstellung einer Ausführungsform einer Belichtungseinheit;
- Figur 18: eine schematische Darstellung einer Belichtung innerhalb von Umwandlungsbereichen gemäß einer ersten Betriebsweise;
- Figur 19: eine Darstellung der bei der ersten Betriebsweise erzeugten Spannungen zur Steuerung der Ablenkeinheit;
- Figur 20: eine Darstellung entsprechend Fig. 19 und
- Figur 21: eine Darstellung der Ansteuerung der jeweiligen Laserstrahlungsquelle in Abhängigkeit von den in Fig. 20 dargestellten Spannungen zur Steuerung der Ablenkeinheit;
- Figur 22: eine Darstellung der Belichtung innerhalb von mehreren Umwandlungsbereichen entsprechend Fig. 18 bei einer dritten Betriebsweise;
- Figur 23: eine Darstellung der der dritten Betriebsweise angelegten Spannungen;
- Figur 24: eine Darstellung der bei einer vierten Betriebsweise angelegten Spannungen entsprechend Fig. 20;
- Figur 25: eine Darstellung der Ansteuerung der Laserstrahlungsquelle in Abhängigkeit von den in Fig. 24 angelegten Spannungen zur Steuerung der Ablenkeinheit bei der vierten Betriebsweise;
- Figur 26: eine Darstellung einer Belichtung innerhalb von Umwandlungsbereichen bei einer fünften Betriebsweise;
- Figur 27: eine Darstellung der Ansteuerung der Ablenkeinheit zur Bewegung des Belichtungsflecks;
- Figur 28: eine Darstellung der Spannung zur Bewegung des Belichtungsflecks entsprechend Fig. 27 und
- Figur 29: eine Darstellung der Ansteuerung der Laserstrahlungsquelle in Abhängigkeit von den in Fig. 28 dargestellten Spannungen zur Steuerung der Ablenkeinheit.

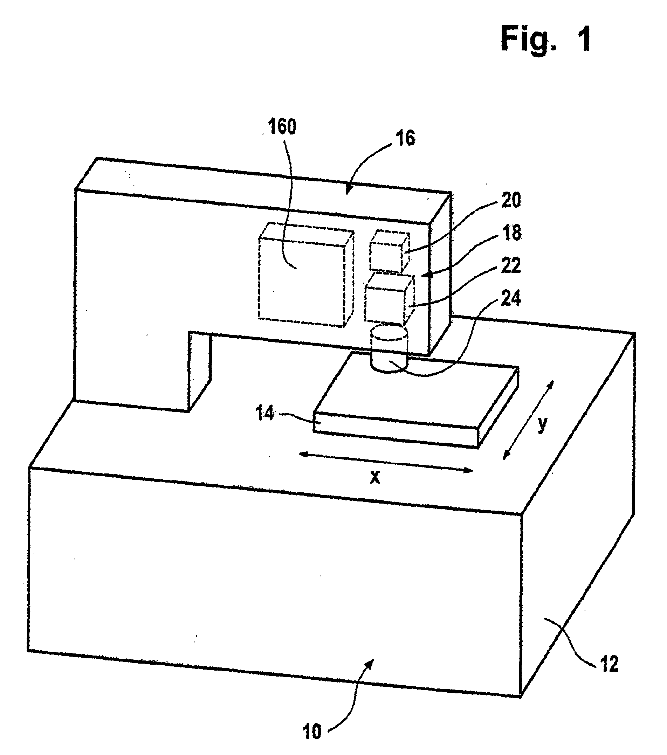

Ein Ausführungsbeispiel einer erfindungsgemäßen Lithografiebelichtungseinrichtung, dargestellt in Figur 1, umfaßt ein als Ganzes mit 10 bezeichnetes Maschinengestell, mit einem Grundkörper 12, an welchem ein Tisch 14 in zwei senkrecht zueinander verlaufenden Richtungen, beispielsweise einer X-Richtung und einer Y-Richtung durch einen nicht dargestellten Antrieb bewegbar gelagert ist.

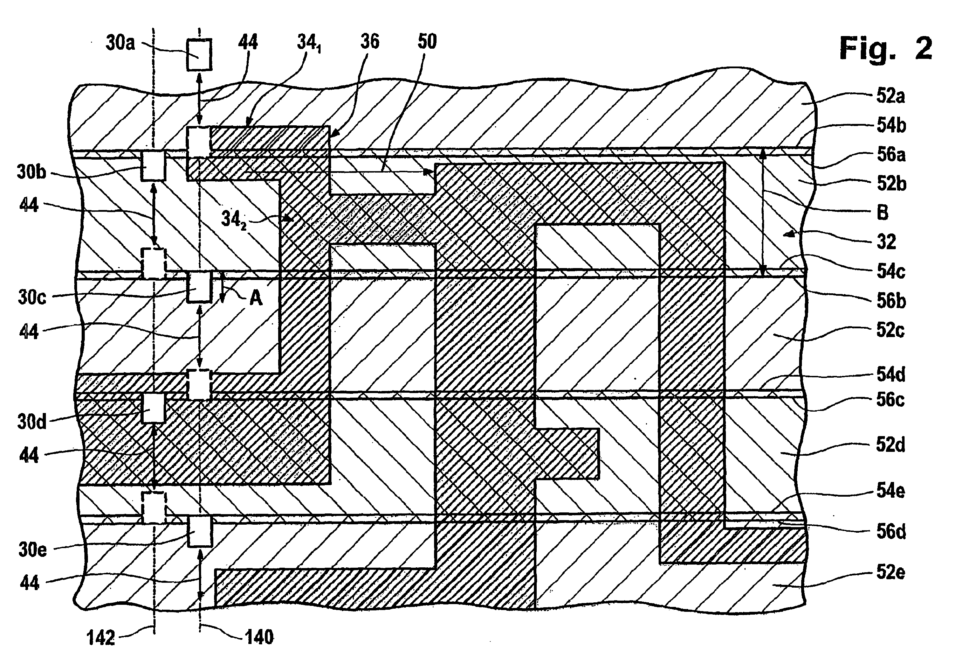

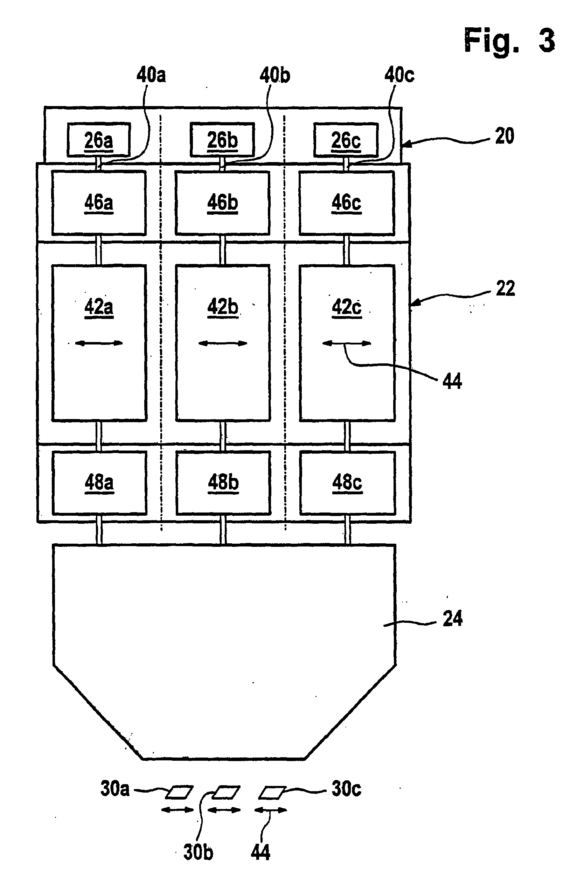

Über dem Grundkörper 12 erhebt sich ein sich über den Tisch 14 und im Abstand von diesem erstreckender Arm 16, in welchem, wie schematisch in Figur 1 dargestellt, eine Belichtungseinheit 18 angeordnet ist, welche in einer Strahlungsquelleneinheit 20 zusammengefaßt eine Vielzahl von Laserstrahlungsquellen aufweist. An diese Strahlungsquelleneinheit 20 schließt sich eine als Ganzes mit 22 bezeichnete Ablenkeinrichtung und auf diese folgt eine als Ganzes mit 24 bezeichnete Fokussierungsoptik, welche letztlich die Laserstrahlung jeder Laserstrahlungsquelle 26 als Belichtungsfleck 30 auf eine auf dem Tisch 14 angeordnete und auf einem Träger aufgetragene lichtempfindliche Schicht 32 abbildet, um in der lichtempfindlichen Schicht 32 Umwandlungsbereiche 34 zu erzeugen, in welchen die lichtempfindliche Schicht 32 von einem Ausgangszustand in einen Endzustand umgewandelt ist, und welche insgesamt eine belichtete Struktur 36 ergeben (Fig. 2, 3). Auch die Ablenkeinrichtung 22 und die Fokussierungsoptik 24 sind Teil der Belichtungseinheit 18.

Wie nochmals in Figur 3 im Einzelnen, jedoch nach wie vor schematisiert dargestellt, umfaßt die Strahlungsquelleneinheit 22 eine Vielzahl von Laserstrahlungsquellen 26, die beispielsweise Halbleiterdiodenlaser sein können oder Halbleiterlaser mit zugeordneter lichtlinearer optischer Frequenzkonversion, d.h. Frequenzverdopplung.

Die von den einzelnen Laserstrahlungsquellen 26 erzeugte Laserstrahlung 40 wird entweder in Form von Freistrahlpropagation oder über Lichtleiter der als Ganzes mit 22 bezeichneten Ablenkeinrichtung zugeführt.

Die Ablenkeinrichtung 22 umfaßt für die Laserstrahlung 40 jeder der Laserstrahlungsquellen 26 jeweils eine Ablenkeinheit 42 mit welcher die Laserstrahlung 40 in einer Ablenkrichtung 44, wie nachfolgend noch im einzelnen beschrieben, ablenkbar ist.

Ferner ist zwischen jeder der Laserstrahlungsquellen 26 und den entsprechenden Ablenkeinheiten 42 noch eine Strahlformungseinheit 46 vorgesehen.

Ferner ist zwischen jeder der Ablenkeinheiten 42 und der Fokussierungsoptik 24 ebenfalls nochmals eine Strahlformungseinheit 48 vorgesehen, welche beispielsweise zur Erzeugung von ungefähr rotationssymmetrischen Laserstrahlungsbündeln vor Eintritt derselben in die Fokussierungsoptik 24 dient.

Die Fokussierungsoptik 24 erzeugt ihrerseits in der lichtempfindlichen Schicht 32 die einzelnen, jeder der Laserstrahlungsquellen 26 zugeordneten Bildflecken 30.

Wie in Figur 2 dargestellt, erfolgt beim Belichten der lichtempfindlichen Schicht 32 ein Bewegen des Tisches 14 mit der darauf angeordneten lichtempfindlichen Schicht 32 in einer Belichtungsbewegungsrichtung 50, die beispielsweise mit der X-Richtung oder der Y-Richtung in Figur 1 zusammenfallen kann oder auch durch Addition einer Bewegung in X- und Y-Richtung entstehen kann.

Ferner verläuft die Belichtungsbewegungsrichtung 50 stets so, daß die Ablenkrichtungen 44, in welche die Laserstrahlung ablenkbar ist, quer zur Belichtungsbewegungsrichtung 50 verlaufen, wobei nicht zwingenderweise ein senkrechter Verlauf erforderlich ist, sondern ebenfalls eine geringfügige Schrägstellung möglich ist.

Durch die Ablenkung der Laserstrahlung 40 in Richtung der Ablenkrichtungen 44 ist auf der lichtempfindlichen Schicht 32 der aus der jeweiligen Laserstrahlung 40 entstehende Belichtungsfleck 30 ebenfalls in der Ablenkrichtung 44 verschiebbar, und zwar zwischen einer in Fig. 2 durchgezogen gezeichneten Extremstellung und einer in Fig. 2 gestrichelt gezeichneten Extremstellung, wobei beide Extremstellungen eine Breite B von Streifenbereichen 52 festlegen, innerhalb welcher mit dem jeweiligen Belichtungsfleck 30 Umwandlungsbereiche 34 in der lichtempfindlichen Schicht 32 erzeugbar sind. Die Breite B entspricht dabei einem Vielfachen einer Ausdehnung A des jeweiligen Belichtungsflecks 30 in der Ablenkrichtung 44.

Die Streifenbereiche 52 sind vorzugsweise so angeordnet, daß deren äußere Ränder 54 und 56 sich geringfügig überlappen, um sicherzustellen, daß die von dem einen der Streifenbereiche 52 zugeordneten Belichtungsfleck 30 erzeugten Umwandlungsbereiche 34 mit den von dem nächstliegenden Streifenbereich 52 zugeordneten Belichtungsfleck 30 erzeugten Streifenbereichen 52 zusammenhängend erzeugbar sind.

So ist beispielsweise mit dem Belichtungsfleck 30a in der gestrichelten, unmittelbar an den Rand 56a anschließenden Stellung und dem Belichtungsfleck 30b in seiner unmittelbar an der Rand 54B anschließenden Stellung der Umwandlungsbereich 34₁ als zusammenhängender Umwandlungsbereich erzeugbar.

Ferner ist beispielsweise sowohl mit dem Belichtungsfleck 34a in einer an den Rand 56a anschließenden Stellung, den Belichtungsflecken 30b und 30c in sämtlichen zwischen den Rändern 54b und 56b sowie 54c und 56c liegenden Stellungen und dem Belichtungsfleck 30b in seinen über etwas mehr als die Hälfte des Streifenbereichs 52d ausgehend von dem Rand 54d liegenden Stellungen der Umwandlungsbereich 34₂ als zusammenhängender Umwandlungsbereich aufgrund der Überlappung der Streifenbereiche 52a, 52b, 52c und 52d erzeugbar.

Die einzelnen Ablenkeinheiten 42 arbeiten bei der erfindungsgemäßen Lithografiebelichtungseinrichtung nach folgendem Prinzip:

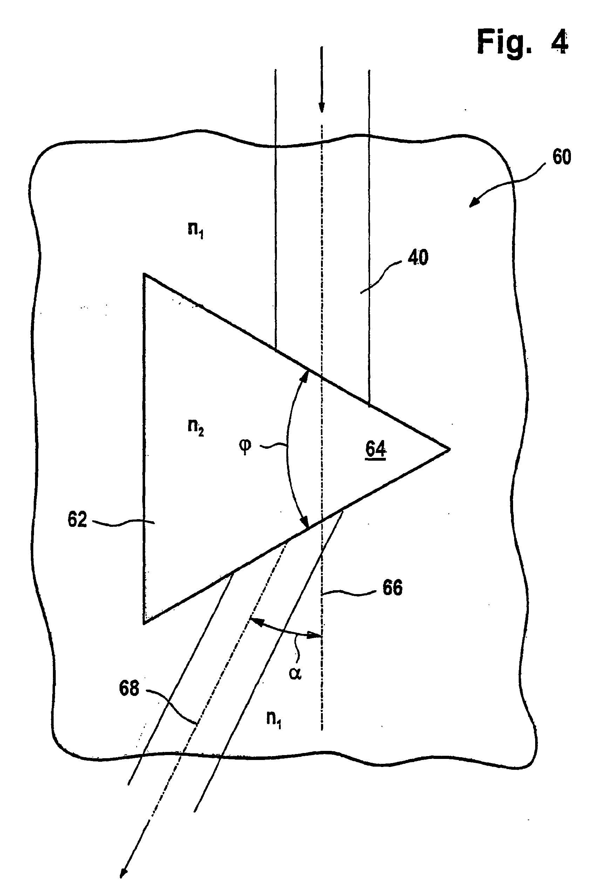

Die von der jeweiligen Laserstrahlungsquelle 26 kommende Laserstrahlung 40 durchsetzt nach Durchlaufen der Strahlformungseinheit 46, die nachfolgend noch im Einzelnen beschrieben wird, ein erstes Medium 60, welches die Brechzahl n₁ aufweist. Von dem ersten Medium 60 geht die Laserstrahlung 40 über in einen, beispielsweise als Prisma oder Linsenhälfte ausgebildeten strahlablenkenden Raumbereich 62, innerhalb von welchem ein zweites Medium 64 eine variable einstellbare Brechzahl n₂ aufweist. die größer als n₁ ist, und geht wiederum nach Durchsetzen des Raumbereichs 62 in das erste Medium mit der Brechzahl n₁ über (Fig.4).

Dadurch erfolgt aufgrund der Brechzahl n₂ des zweiten Mediums 64 durch den Raumbereich 62 eine Ablenkung der Laserstrahlung 40 von der ursprünglichen Richtung 66 in eine gegenüber der ursprünglichen Richtung in einem Winkel α verlaufende Austrittsrichtung 68, so daß eine Ablenkung der Laserstrahlung 40 durch den Raumbereich 62 stattfindet.

Der Winkel α hängt dabei davon ab, wie stark sich die Brechzahl n₂ des zweiten Mediums 64 von der Brechzahl n₁ des ersten Mediums 60 unterscheidet, so daß durch Variation der Brechzahl n₂ gleichzeitig auch der Winkel α variabel ist.

Näherungsweise gilt im Fall eines als Prisma ausgebildeten Raumbereichs 62 für kleine Winkel α: α ≈ (n₂-n₁) ϕ, wobei ϕ der den prismatischen Raumbereich 62 bestimmende Prismenwinkel ist.

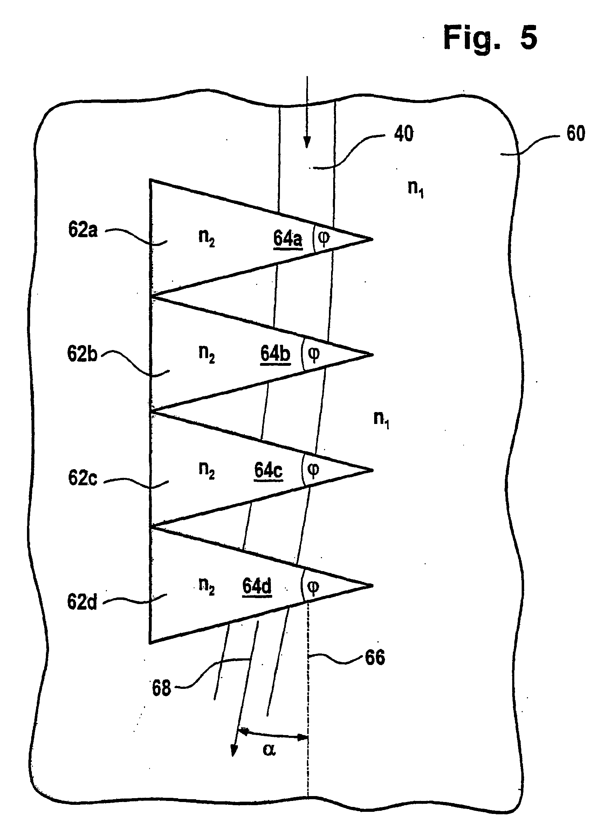

Die Wirksamkeit des Raumbereichs 62 läßt sich noch erhöhen, wenn, wie in Figur 5 dargestellt, mehrere aufeinanderfolgende Raumbereiche 62a bis 62b, jeweils aus dem zweiten Medium, eingesetzt werden, durch die die Laserstrahlung 40 nacheinander hindurchläuft, so daß die sich durch jeden einzelnen der Raumbereiche 62a bis 62d erzeugte Ablenkung aufsummieren läßt und insgesamt die Austrittsrichtung 68 in einem Winkel α zur ursprünglichen Richtung 66 verläuft, der die Summe der in jedem der Raumbereiche erreichten Ablenkungen darstellt.

Derartige strahlablenkende Raumbereiche 62 lassen sich wie folgt realisieren:

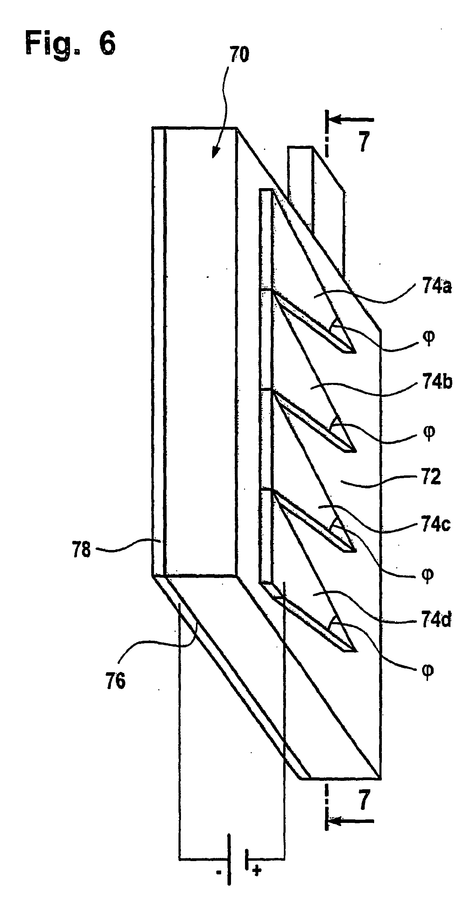

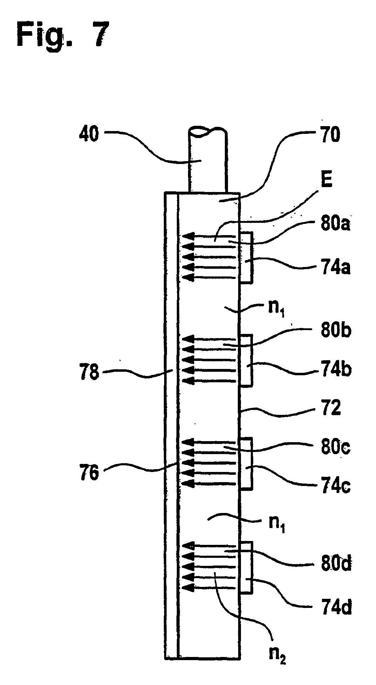

Bei einem ersten Ausführungsbeispiel einer erfindungsgemäßen Ablenkeinrichtung, dargestellt in Figur 6 und Figur 7, wird eine Wellenleiterplatte 70 auf einer ersten Seite 72 mit einem Satz erster Elektroden 74a bis 74d versehen, die elektrisch leitend miteinander verbunden sind und eine Prismenform mit dem Prismenwinkel ϕ aufweisen.

Ferner wird eine zweite, der ersten Seite 72 gegenüberliegende Seite 76 beispielsweise mit einer zweiten, durchgehenden Elektrode 78 versehen.

Ist nun die Wellenleiterplatte 70 aus einem elektrooptischen Material hergestellt, wie beispielsweise Lithiumniobat, Lithiumtantalat, oder einem polaren Halbleiter, wie Aluminium-Gallium-Nitrit, so läßt sich beim Anlegen einer elektrischen Spannung an der ersten Elektrode 74 und der zweiten Elektrode 78 ein elektrisches Feld E zwischen der ersten Elektrode 74 und der zweiten Elektrode 76 erzeugen, welches in der Wellenleiterplatte 70 Volumenbereiche 80a bis 80d durchsetzt, die aufgrund der prismatischen Form der ersten Elektrode 74 eine Form eines prismatischen räumlichen Körpers aufweisen.

Aufgrund der elektrooptischen Eigenschaften des Materials der Wellenleiterplatte 70 weist dieses nun außerhalb der Volumenbereiche 80a bis 80d eine Brechzahl n₁ auf, während innerhalb der Volumenbereiche 80a bis 80d durch die Wirkung des elektrische Feldes E die Brechzahl n₁ geändert werden kann und je nach Größe des elektrischen Feldes E eine Brechzahl n₂ aufweist, die sich von der Brechzahl n₁ unterscheidet.

Damit läßt sich ausgehend von dem Zustand, daß an den Elektroden 74 und 78 keine elektrische Spannung anliegt und somit kein elektrisches Feld E in den Volumenbereichen 80 auftritt, so daß folglich n₁ = n₂ ist, und somit die Laserstrahlung 40 keinerlei Ablenkung erfährt und sich in der ursprünglichen Richtung 66 durch die Wellenleiterplatte 70 durch unverändert ausbreitet, mit zunehmender Spannung an den Elektroden 74 und 78 ein zunehmend größeres elektrisches Feld E erzeugen, so daß sich die Brechzahl n₂ im Volumenbereich 80 entsprechend dem elektrischen Feld E einstellen läßt, wodurch wiederum - wie bereits dargelegt - der Winkel α zwischen der ursprünglichen Richtung 66 und der Austrittsrichtung 68 einstellbar ist.

Die Ablenkung läßt sich bei mehreren strahlablenkenden Raumbereichen 62 entweder dadurch einstellen, daß die Spannung zwischen die Elektroden 74 und 78 variabel eingestellt wird.

Andererseits ist es aber auch denkbar, bei mehreren Raumbereichen 62 diese einzeln anzusteuern und ausgehend von einem festgelegten Spannungsniveau entweder keinen der Raumbereiche 62 oder sukzessive eine immer größer werdende Anzahl von Raumbereichen mit der Spannung mit dem festgelegten Spannungsniveau anzusteuern und somit stufenweise die Ablenkung der Laserstrahlung zu vergrößern.

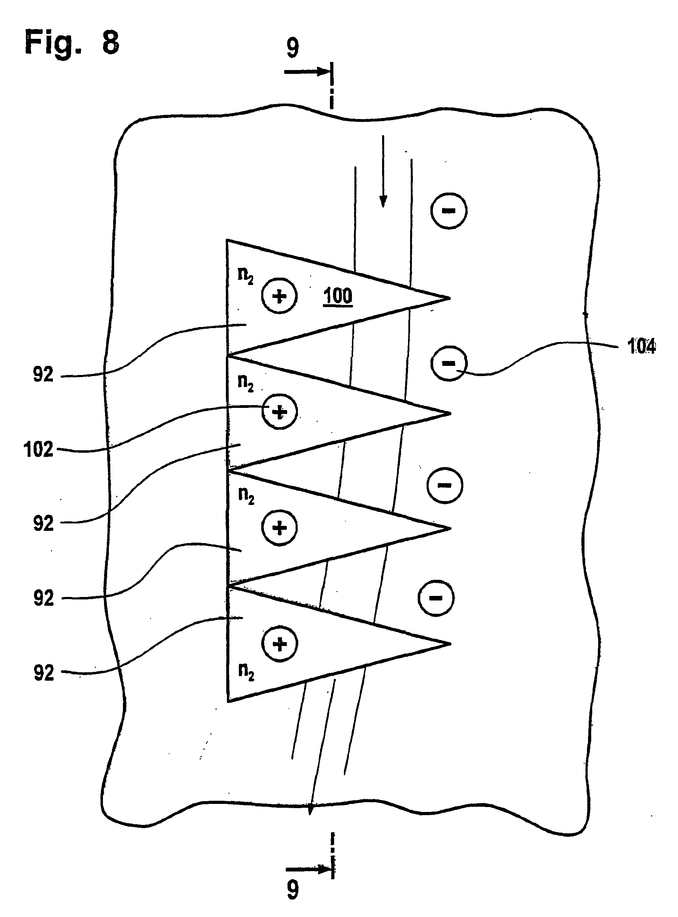

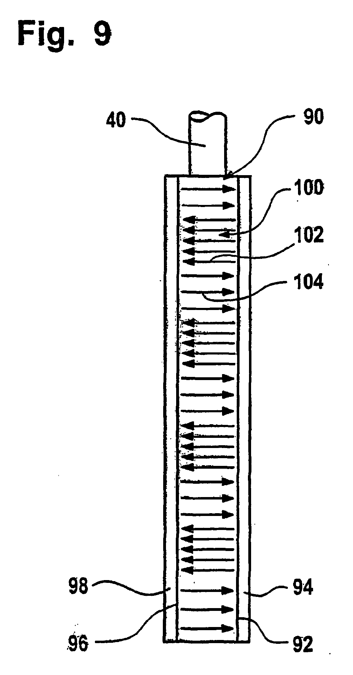

Eine zweites Ausführungsbeispiel einer erfindungsgemäßen Ablenkeinheit 42 sieht für die Ausbildung von Raumbereichen 62, wie in Figur 8 und Figur 9 dargestellt, vor, daß eine Wellenleiterplatte 90 ebenfalls aus einem elektrooptischen Material allerdings mit Domänenstruktur hergestellt ist.

Die Wellenleiterplatte 90 trägt dabei in gleicherweise wie bei dem ersten Ausführungsbeispiel auf einer ersten Seite 92 eine erste, allerdings diese durchgehend überdeckende Elektrode 94 und auf einer zweiten Seite 96 eine zweite, diese durchgehend überdeckende Elektrode 98.

Ferner sind innerhalb der Wellenleiterplatte 90 Volumenbereiche 100 vorhanden, in denen Domänen des elektrooptischen Materials mit einer Polarisation 102 vorliegen, während außerhalb der Volumenbereiche 100 zusammenhängende, insgesamt eine Domäne bildende Bereiche mit einer zweiten Polarisation 104 vorliegen, die genau entgegengesetzt zur ersten Polarisation 102 ausgerichtet ist.

Die ersten Volumenbereiche 100 mit der ersten Polarisation 102 die Bereiche mit der zweiten Polarisation 104weisen ohne anliegendes elektrisches Feld E dieselbe Brechzahl n₁ auf.

Je nach Spannung zwischen den Elektroden 94 und 98 läßt sich entweder die Brechzahl im Bereich der ersten Polarisation 102 oder der zweiten Polarisation 104 ausgehend von ihrem Ausgangszustand reduzieren, wobei aufgrund der alle Domänen übergreifenden Elektroden 94 und 98 jeweils die Brechzahl im Bereich der anderen Polarisation 104 bzw. 102 erhöht wird.

Damit ist durch Anlegen des elektrischen Feldes an die Elektroden 94 und 98 die Differenz zwischen den Brechzahlen der Domänen mit den Polarisationen 102 und 104 einstellbar.

Bei allen Ausführungsbeispielen von elektrooptisch arbeitenden Ablenkeinheiten 42 ist vorzugsweise die Laserstrahlung 40 polarisiert zu wählen und so auszurichten, daß sie parallel zu dem anlegbaren elektrischen Feld E verläuft.

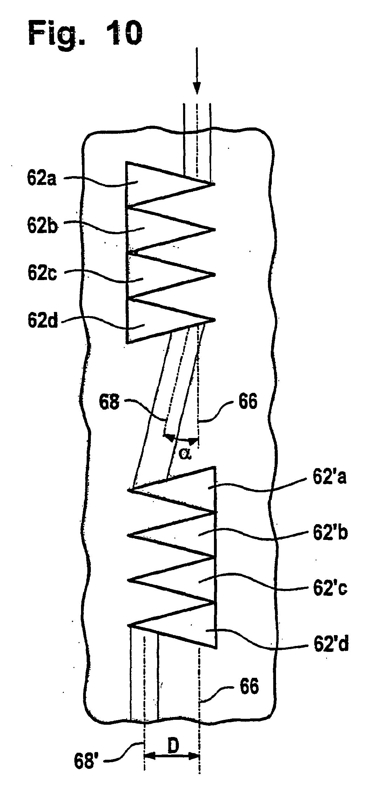

Da sowohl bei der Ausführungsform gemäß den Figuren 6 und 7 als auch bei der Ausführungsform gemäß Figur 8 und 9 die Laserstrahlung 40 nach Durchlaufen der Prismenbereiche 62a bis 62d in der Austrittsrichtung 68 schräg zur ursprünglichen Richtung 66 verläuft, sind vorzugsweise bei einem weiteren Ausführungsbeispiel gemäß Figur 10 zusätzlich komplementär wirkende Raumbereiche 62'a bis 62'd vorgesehen, die die Laserstrahlung 40 wieder um einen Winkel α in entgegengesetzter Richtung ablenken, so daß letztlich die Austrittsrichtung 68' nach Durchlaufen der Raumbereiche 62a bis 62d und der komplementären Raumbereiche 62'a bis 62'd parallel zur ursprünglichen Richtung 66, jedoch um einen Abstand D gegenüber dieser versetzt, verläuft.

Somit kann die sich in Austrittsrichtung 68' ausbreitende Laserstrahlung 40 ohne zusätzliche Maßnahmen aufgrund schrägen Einfalls durch die Fokussierungsoptik 24 in den Belichtungsfleck 30 abgebildet werden.

Im Zusammenhang mit der bisherigen Erläuterung der einzelnen Ausführungsbeispiele wurde auf die Funktion der Strahlformungseinheiten 46 nicht näher eingegangen.

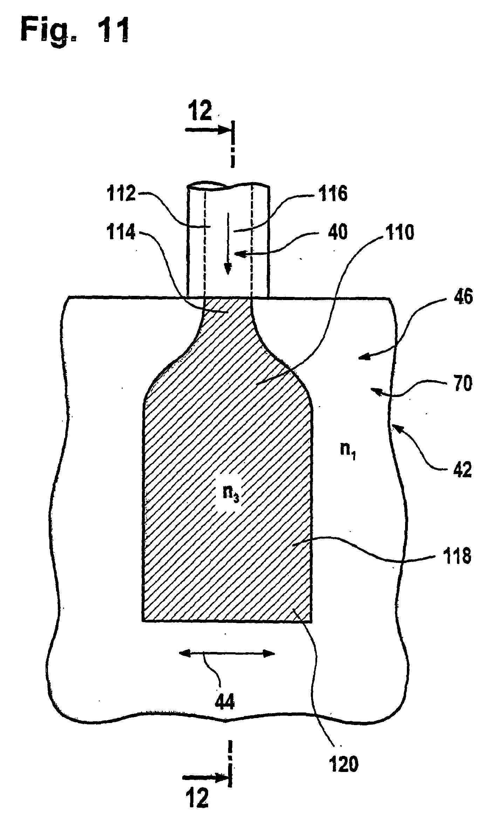

Um die Divergenz der einfallenden Laserstrahlung 40 in der Ablenkrichtung 44 zu begrenzen, ist beispielsweise in der Wellenleiterplatte 70, welche die Brechzahl n₁ aufweist, ein die Laserstrahlung 40 führender Raumbereich 110 vorgesehen, welcher die Brechzahl n₃ aufweist (Fig. 11).

Dieser die Laserstrahlung 40 führende Raumbereich 110 weist einen sich an einen die Laserstrahlung 40 führenden Wellenleiter 112 anschließenden Anschlußbereich 114 auf, welcher in Ablenkrichtung 44 an die Ausdehnung eines Kernbereichs 116 in Ablenkrichtung 44 angepaßt ist und sich dann ausgehend von dem Anschlußbereich 114 in einen Bandbereich 118 erweitert, dessen Ausdehnung in Ablenkrichtung 44 mehr als das zehnfache der Ausdehnung des Anschlußbereichs 114, vorzugsweise mehr als das zwanzigfache desselben beträgt. Die Ausdehnung des Bandbereichs 118 in Ablenkrichtung 44 liegt beispielsweise zwischen dem mehr als zehnfachen der Ausdehnung des Anschlußbereichs 114 und dem mehr als fünfzigfachen desselben.

Durch den Bandbereich 118 besteht die Möglichkeit, die Laserstrahlung 40 nach Austreten aus einem Ende 120 des Bandbereichs 118 in der Wellenleiterplatte 70 mit einer Divergenz zu führen, die deutlich geringer ist als die maximale Verschiebung der Laserstrahlung 40 in Ablenkrichtung 42 durch die jeweilige Ablenkeinheit 42.

Vorzugsweise ist dabei für jede der Ablenkeinheiten 42 eine einige Strahlformungseinheit 46 vorgesehen, welche in die Wellenleiterplatte 70 der Ablenkeinheit 42 integriert ist.

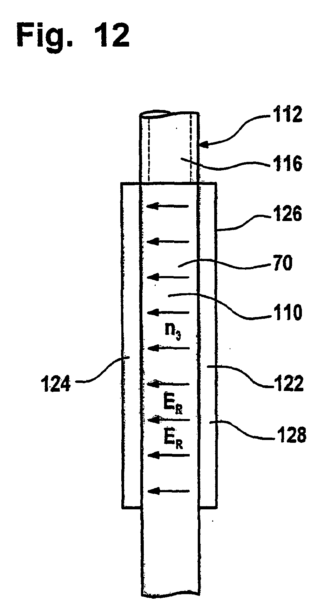

Der Raumbereich 110 mit der Brechzahl n₃ läßt sich vorzugsweise in der Wellenleiterplatte 70 dadurch erzeugen, daß, wie in Figur 12 dargestellt, auf gegenüberliegenden Seiten des Raumbereichs 110 Elektroden 122 und 124 vorgesehen sind, mit denen ein elektrisches Feld Eᵣ in der Wellenleiterplatte 70 aus elektrooptischem Material erzeugbar ist, das zu einer Veränderung der Brechzahl n₁ auf die Brechzahl n₃ führt. Vorzugsweise ist dabei eine der Elektroden 122 oder 124 entsprechend der Ausdehnung des Raumbereichs 110 in Ablenkrichtung 44 geformt, d.h., daß beispielsweise die Elektrode 122 einen in Ablenkrichtung 44 an den Kernbereich 116 des Wellenleiters 112 angepaßten Abschnitt 126 aufweist, der sich in Ablenkrichtung 44 erweitert zu einem den Bandbereich 118 des Raumbereichs 110 festlegenden Abschnitt 128.

Die andere Elektrode 124 kann dabei entweder entsprechend der Elektrode 122 geformt sein oder sich über die gesamte Wellenleiterplatte 70 erstrecken und beispielsweise mit der zweiten Elektrode 78 eine Einheit bilden.

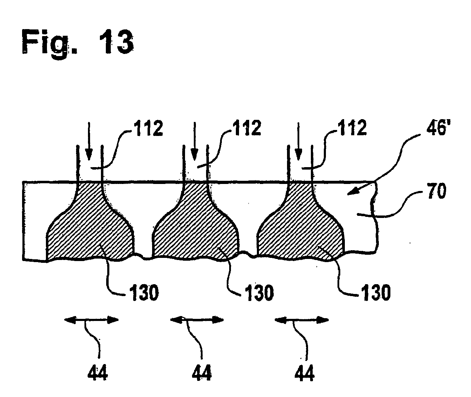

Alternativ zur Ausbildung des Raumbereichs 110 durch Erzeugen des elektrischen Feldes Eᵣ ist bei einer anderen Ausführungsform der erfindungsgemäßen Strahlformungseinheit 46 vorgesehen, daß in der Wellenleiterplatte 70 GRIN-Linsen 130 im Anschluß an die Wellenleiter 112 vorgesehen sind, die durch einen symmetrisch zu einer Mittelachse variierenden Brechungsindex ebenfalls eine Aufweitung der Laserstrahlung in Ablenkrichtung 44 derart bewirken, daß die Divergenz der sich in der Wellenleiterplatte 70 ausbreitenden Laserstrahlung kleiner ist als die durch die Ablenkeinheit 42 erzeugbare maximale Ablenkung der Laserstrahlung (Fig. 13).

Derartige GRIN-Linsen lassen sich vorzugsweise durch Eindiffusion von den Brechungsindex in der Wellenleiterplatte 70 variierenden Stoffen erzeugen.

Die im Zusammenhang mit der Integration in die Wellenleiterplatte 70 beschriebenen Strahlformungseinheiten 46 lassen sich jedoch in gleicher Weise auch in der Wellenleiterplatte 90 oder bei anderen Ausführungsbeispielen realisieren.

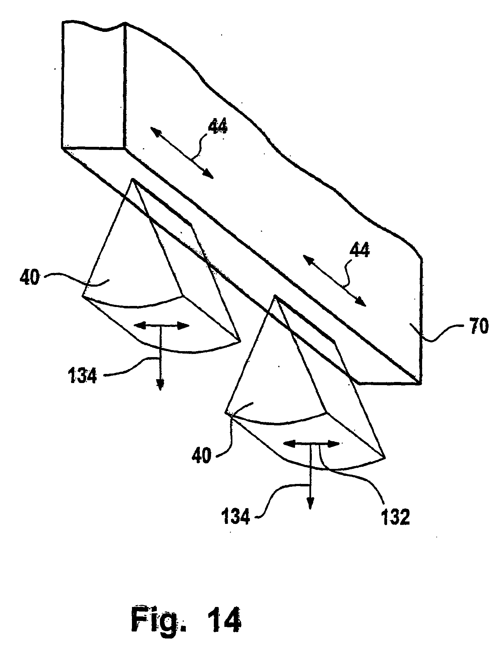

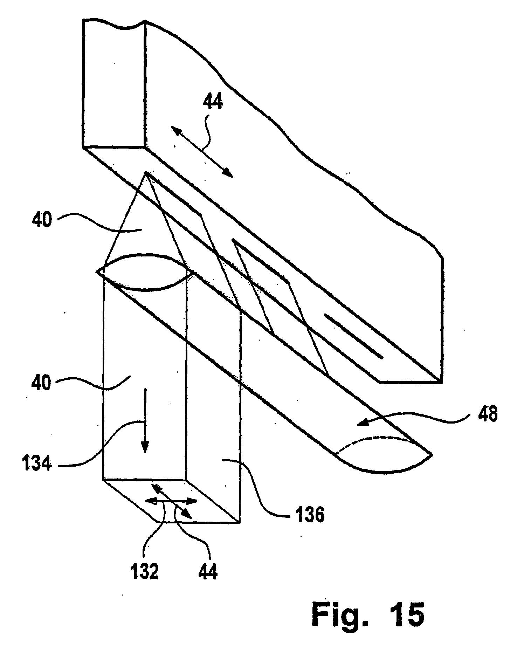

Da durch die Strahlformungseinheit 46 die Laserstrahlung 40 sich in Form eines in Ablenkrichtung 44 verbreiterten Bandes durch die Ablenkeinheit 42 ausbreitet, tritt, wie in Figur 14 dargestellt, aus der Wellenleiterplatte 70 die Laserstrahlung 40 in Form eines in der Ablenkrichtung 44 ebenfalls verbreiternden Bandes aus, was dazu führt, daß sich die Laserstrahlung 40 nach Verlassen der Wellenleiterplatte 70 in einer Richtung 132 quer zu ihrer Ausbreitungsrichtung 134 und quer zur Ablenkrichtung 44 stark divergent ausbreitet. Aus diesem Grund ist vorgesehen, mit der Strahlformungsoptik 48, dargestellt in Figur 15, aus der jeweils divergenten Laserstrahlung 40 ein Strahlungsbündel 136 zu formen, welches näherungsweise in der Ablenkrichtung 44 und der Richtung 132 quer zur Ablenkrichtung 44 dieselbe Ausdehnung aufweist. Dieses Strahlungsbündel 136 läßt sich dann in der Fokussierungsoptik 24 bei konventionellem Aufbau derselben verkleinern.

Bei einer Ausführung der Ablenkeinheit 42 entsprechend den voranstehend beschriebenen Ausführungsbeispielen, beispielsweise dem Ausführungsbeispiel gemäß den Figuren 6 und 7, besteht das Problem, daß sich die erste, prismenähnliche Form der Elektrode 74 stets über die Ausdehnung der Laserstrahlung in der Ablenkrichtung 44 hinaus erstrecken muß.

Aus diesem Grund ist es vorteilhaft, die einer Folge von nebeneinander liegenden Streifenbereichen 52a bis 52d zugeordneten Ablenkeinheiten 42a bis 42d nicht in einer Ebene anzuordnen, sondern in mehreren Ebenen, beispielsweise in zwei Ebenen 140 und 142.

Wie bereits in Figur 2 dargestellt, führt dies dazu, daß auch die Belichtungsflecken 30 in den unterschiedlichen Ebenen 140 und 142 liegen.

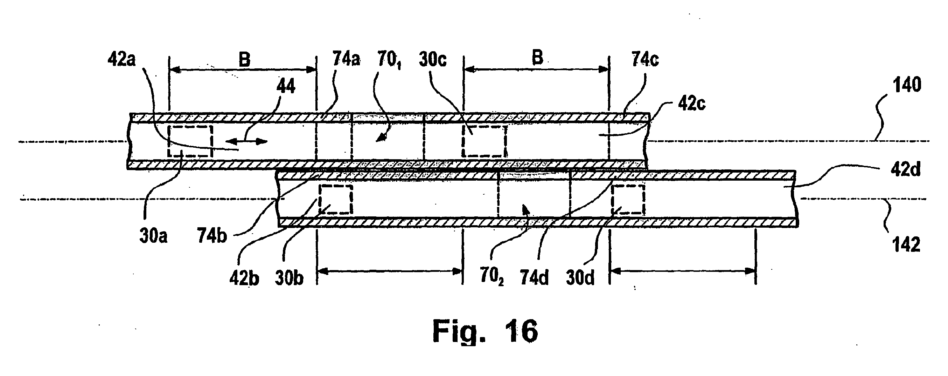

Beispielsweise sind die Ablenkeinheiten 42a und 42c, wie in Figur 16 dargestellt, d.h. die jeweils übernächsten Ablenkeinheiten 42, in der Ebene 140 angeordnet und die dazwischen liegenden Ablenkeinheiten, wie beispielsweise die Ablenkeinheiten 42b und 42d, in der zweiten, dazu verlaufenden Ebene 142 parallel dazu. Dies erlaubt es, die ersten Elektroden 74 jeweils mit der notwendigen Größe und somit Ausdehnung in Ablenkrichtung 44 über die Laserstrahlung hinaus auszubilden, ohne daß diese über die Breite B des jeweiligen Streifenbereichs 52 hinaus erstreckenden Elektroden 74 einen Zwischenraum zwischen den Streifenbereichen 52 erforderlich machen.

Damit besteht in der Ablenkrichtung 44 ausreichend Raum zur Ausbildung der Elektroden 74 und dennoch lassen sich die Streifenbereiche 52 unmittelbar aneinander anschließend realisieren.

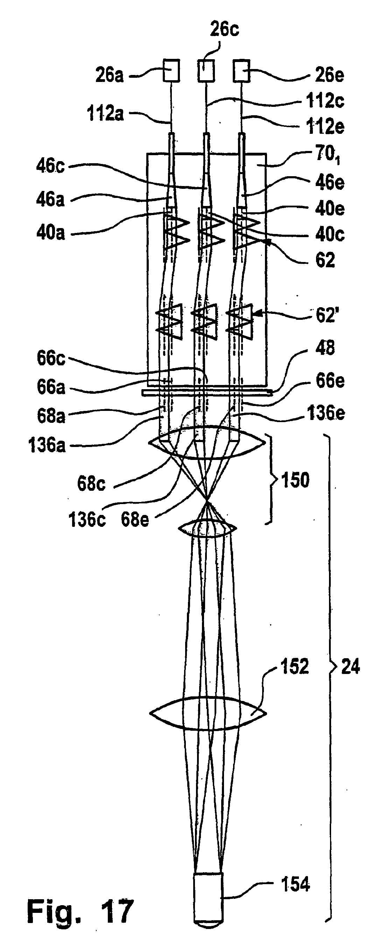

Ein Ausschnitt einer Ausführungsform, die gemäß dem Aufbau der Figur 16 arbeitet und zu Bildflecken in der Anordnung gemäß Figur 2 führt, ist in Figur 17 dargestellt, wobei aufgrund der Art der Darstellung lediglich die in der Zeichenebene, die mit der Ebene 140 zusammenfällt, liegenden Elemente dargestellt sind. So erfolgt die Erzeugung der Laserstrahlung durch die Laserstrahlungsquellen 26a, 26c und 26e und die Laserstrahlung wird über Lichtleiter 112a, 112c und 112e zu der Wellenleiterplatte 70₁ geführt. In dieser Wellenleiterplatte sind - wie bereits beschrieben - die Strahlformungseinheiten 46a, 46c und 46e für die Laserstrahlung 40a, 40c, 40e aus den einzelnen Laserstrahlungsquellen 26a, 26c und 26e vorgesehen, die die Laserstrahlung 40a, 40c und 40e zu einem sich in der Ablenkrichtung 44 erweiternden Band aufweiten.

Durch die Prismeneinheiten 62 und 62'besteht die Möglichkeit, die Laserstrahlung 40a, 40c und 40e gegenüber der ursprünglichen Richtung 66a, 66c und 66e zu versetzen, beispielsweise in die dargestellten Austrittsrichtungen 68a, 68c und 68e, die untereinander nicht gleich weit in der Ablenkrichtung 44 sein müssen, sondern unterschiedlich sein können.

Die Strahlformungseinheit 48 formt dann aus den Laserstrahlungen 40a, 40c und 40e die Strahlungsbündel 136a, 136c und 136e, die dann in die als Ganzes mit 24 bezeichnete Fokussierungsoptik eintreten.

Die Fokussierungsoptik weist ihrerseits ein Okular 150, eine Tubuslinse 152 und ein Objektiv 154 auf, wobei das Okular beispielsweise zehnfach und das Objektiv beispielsweise fünfzigfach verkleinert, so daß die entstehenden Bildflecken 30a, 30c und 30e, die in Figur 17 nicht mehr dargestellt sind, ungefähr um einen Faktor fünfhundert gegenüber den Strahlungsbündeln 136a, 136c und 136e verkleinert sind.

Vorzugsweise ist dabei die Tubuslinse 152 zwischen dem Okular 150 und dem Objektiv 154 so angeordnet, daß der Abstand jeweils der Brennweite entspricht.

Zum Betreiben der erfindungsgemäßen Lithografiebelichtungseinrichtung sind unterschiedliche Betriebsweisen denkbar, bei denen eine Steuerung 160 sowohl die Belichtungseinheit 18 als auch die Bewegungen des Tischs 14 steuert.

Zur Erläuterung der einzelnen Betriebsweisen wird aus Gründen der Einfachheit davon ausgegangen, daß die Belichtungsbewegungsrichtung 50 parallel zur X-Richtung verläuft und somit die Ablenkrichtung 44 parallel zur Y-Richtung, wie in Fig. 1 dargestellt.

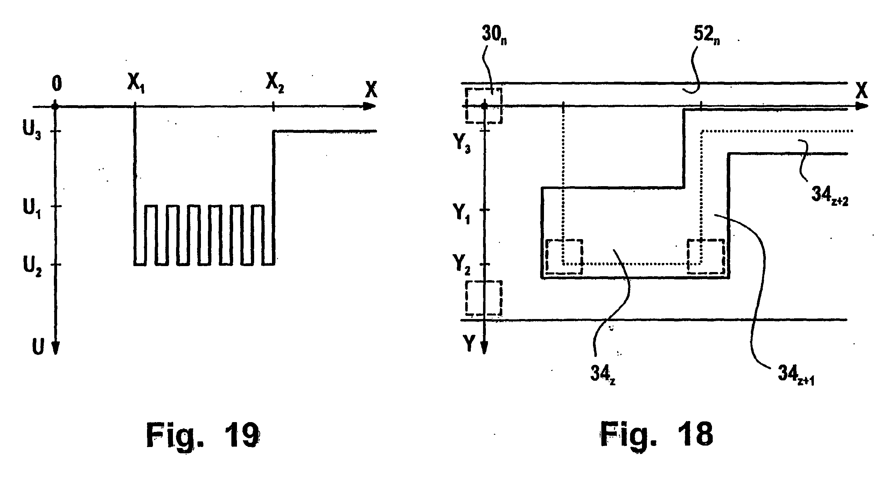

Bei einer ersten Betriebsweise, dargestellt in Fig. 18 bis 20 wird beschrieben, wie sich Umwandlungsbereiche 34_{z}, 34_{z+1} und 34_{z+2} durch die Steuerung 160 durch geeignete Steuerung der Strahlungsquelleneinheit 20 und der Ablenkeinrichtung 22 in Abhängigkeit von der Bewegung des Tisches 14 in X-Richtung steuern lassen. Hierzu wird exemplarisch ein Streifenbereich 52n herausgegriffen.

Um in dem Streifenbereich 52n den Umwandlungsbereich 34_{z} zu erzeugen, ist der Belichtungsfleck 30ₙ bei Erreichen der Koordinate X₁ durch Anlegen einer Spannung U₁ zum Punkt Y₁ und unmittelbar nachfolgend durch Anlegen einer Spannung U₂ zum Punkt Y₂ zu bewegen, wie in Fig. 18 und 19 dargestellt.

Mit dem Bewegen des Belichtungsflecks 30 zu den Positionen Y₁und Y₂ ist noch keine Belichtung im Umwandlungsbereich 34_{z} erfolgt. Hierzu muß die entsprechende Laserstrahlungsquelle 26ₙ eingeschaltet werden.

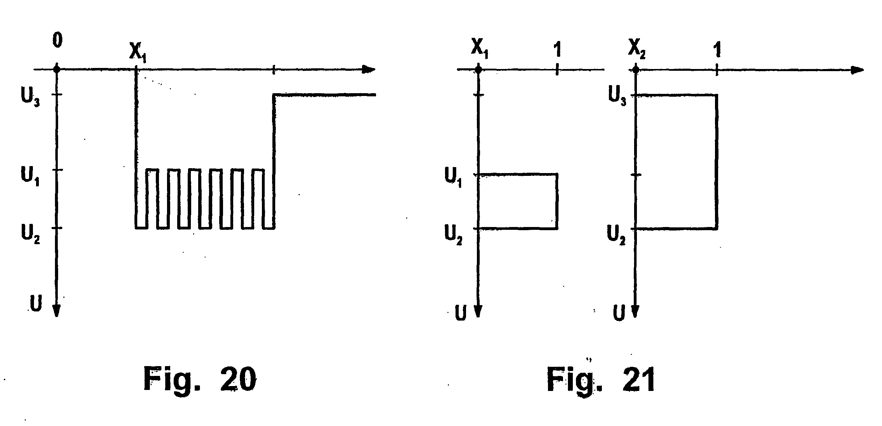

Dies erfolgt, wie in Fig. 20 und 21 dargestellt, bei Erreichen der Position X₁ dadurch, daß bei der Spannung U₁ die Laserstrahlungsquelle 26ₙ eingeschaltet wird und eingeschaltet bleibt, bis auch die Spannung U₂ erreicht wird. Um nun die in Y-Richtung sich erstreckende Flächenausdehnung des Umwandlungsbereichs 34_{z} vollflächig belichten zu können, oszilliert von der Position X₁ des Tisches 14 bis zum Erreichen der Position X₂ des Tisches 14 die Spannung U zwischen dem Wert U₁ und dem Wert U₂, so daß sich der Belichtungsfleck 30ₙ stets zwischen Y₁ und Y₂ bewegt und somit vollflächig und zusammenhängend im Umwandlungsbereich 34_{z} belichtet.

Bei Erreichen der Koordinate X₂ soll jedoch, wie in Fig. 18 dargestellt, der Belichtungsbereich 34_{z+1} belichtet werden. Hierzu wird die Spannung U vom Wert U₂ auf den Wert U₃ erniedrigt, wie in Fig. 18 und 19 dargestellt und gleichzeitig wird bei Erreichen der Position X₂ die Laserstrahlungsquelle 26ₙ eingeschaltet belassen, und zwar zwischen der Spannung U₂ und der Spannung U₃, um dann im Anschluß an den Umwandlungsbereich 34_{z+1} den Umwandlungsbereich 34_{z+2} zu belichten, bleibt die Spannung U₃ erhalten und somit der Belichtungsfleck 30ₙ in seiner Position stehen. In gleicher Weise kann, wie in Fig. 20 und 21 dargestellt, ab der Position X₂ im Bereich zwischen der Spannung U₂und U₃ die Laserstrahlungsquelle 26ₙ eingeschaltet bleiben, da sich die Spannung nicht mehr ändert und bei dem Wert U₃ verbleibt.

Die erste Betriebsweise, dargestellt in den Fig. 19 bis 21 sieht somit vor, daß zur Positionierung des Belichtungsflecks 30ₙ innerhalb des Streifenbereichs 52ₙ beliebige Werte der Spannung U eingestellt werden können, um den Belichtungsfleck 30ₙ innerhalb des Streifenbereichs 52ₙ an beliebiger Stelle in Y-Richtung zu positionieren.

Gleichzeitig ist bei der ersten Betriebsweise vorgesehen, daß die Intensität der Laserstrahlungsquelle 26ₙ zu beliebigen Zeiten und somit zu beliebigen Positionen des Tischs 14 in X-Richtung eingeschaltet werden kann.

Eine zweite Betriebsweise funktioniert im Prinzip genau gleich wie die erste Betriebsweise, die in den Fig. 18 bis 21 beschrieben wurde.

Die zweite Betriebsweise unterscheidet sich von der ersten Betriebsweise lediglich dadurch, daß der Belichtungsfleck 30ₙ in Y-Richtung nicht beliebig positionierbar ist, sondern beispielsweise in zehn über die Breite des Streifenbereichs 52ₙ in gleichen Abständen vorgesehenen Positionen. Dies schränkt selbstverständlich die Flexibilität bei der Positionierung in Y-Richtung auf diese zehn möglichen diskreten Positionen ein.

Die Vorgehensweise bei der zweiten Betriebsweise entspricht genau der der ersten Betriebsweise, allerdings mit der Einschränkung, daß die Spannung U nicht beliebig entsprechend dem gewünschten Wert geändert wird, sondern die Spannung U bei einer gewünschten Positionierung des Belichtungsflecks 30ₙin Y-Richtung so geändert wird, daß die gewünschte Position innerhalb der Größe des Belichtungsflecks 30ₙ in einer der möglichen zehn Positionen liegt.

Dies setzt außerdem voraus, daß in diesen zehn Positionen der Belichtungsfleck 30ₙ mit den jeweils benachbarten Positionen überlappt, so daß auch ein zusammenhängender Umwandlungsbereich 34_{z} herstellbar ist.

Die zehn möglichen Positionen des Belichtungsflecks 34ₙ sind dadurch erreichbar, daß eine Spannungsquelle vorgesehen ist, die lediglich zehn diskrete Spannungswerte erzeugen kann und mit diesen zehn diskreten Spannungswerten ein Ansteuern der jeweils zugeordneten Ablenkeinheit 42ₙ in der vorstehend beschriebenen Weise erfolgt.

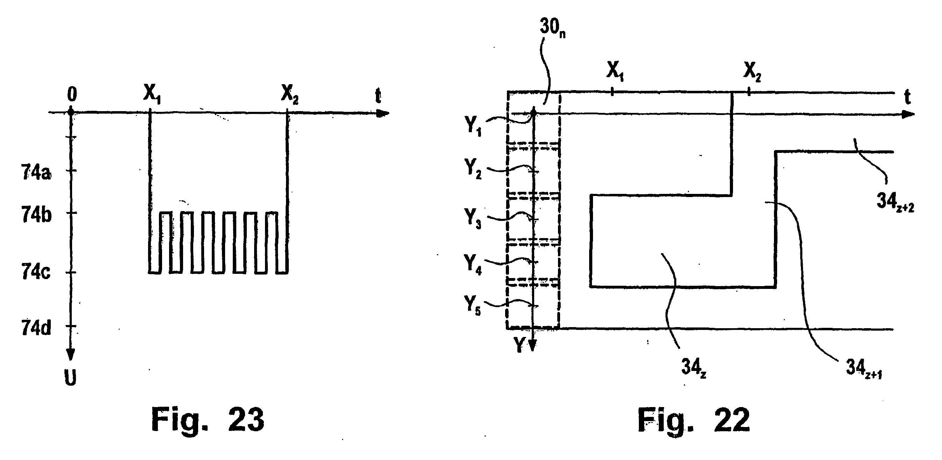

Bei einer dritten Betriebsweise, dargestellt in Fig. 22 und 23 ist vorgesehen, beispielsweise bei dem ersten Ausführungsbeispiel gemäß Fig. 6 und 7 die ersten Elektroden 74a bis 74d elektrisch voneinander getrennt anzuordnen und beispielsweise zum Erreichen der ersten Position Y₁ in Y-Richtung keine der Elektroden 74a bis d anzusteuern, zum Erreichen der zweiten Position Y₂ die Elektrode 74a, zum Erreichen der dritten Position Y₃ die Elektroden 74a und 74b, zum Erreichen der vierten Position Y₄ die Elektroden 74a, 74b und 74c und zum Erreichen der fünften Position Y₅ in Y-Richtung die Elektroden 74a, 74b, 74c und 74d, so daß lediglich die Spannungsquelle einen Spannungswert konstant erzeugen können muß und dieser Spannungswert dann auf die einzelnen Elektroden 74a bis 74d getrennt aufgeschaltet wird, wie in Fig. 22 und 23 dargestellt.

Dabei ist zu erkennen, daß der Umwandlungsbereich 34_{z} beispielsweise dadurch hergestellt wird, daß ab der Position X₁ zunächst die Spannung U auf die Elektroden 74a, 74b und 74c geschaltet wird, dann eine wechselnde Zuschaltung der Elektrode 74c zu den Elektroden 74a und 74b erfolgt und schließlich bei Erreichen der Position X₂ keinerlei Spannung U mehr an alle Elektroden 74a bis b angelegt wird, so daß sich der Belichtungsfleck 30 zur Position Y₁ bewegt und ab der Position X₂ auf der Position Y₁ verbleibt. Dabei wird der Umwandlungsbereich 34_{z+2'} aufgrund der Verschlechterung der Auflösung durch lediglich fünf mögliche Y-Positionen Y₁ bis Y₅ etwas anders ausgeführt als bei der ersten Betriebsweise.

Das Einschalten der Intensität der Laserstrahlungsquelle 26ₙₗ kann dabei in gleicher Weise wie bei der ersten Betriebsweise erfolgen.

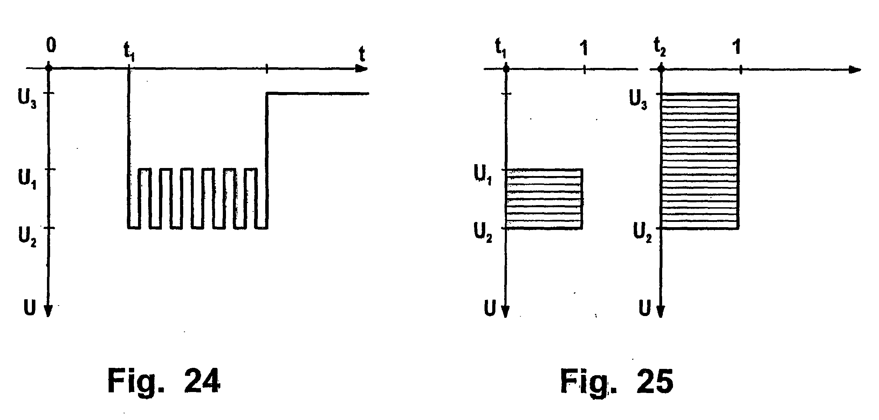

Bei einer vierten Betriebsweise, dargestellt in den Fig. 24 und 25 erfolgt die Positionierung in gleicher Weise wie bei der ersten Betriebsweise, dargestellt in Fig. 18 und 19.

In Abwandlung zur ersten Betriebsweise, wird die entsprechende Laserstrahlungsquelle 26ₙ nicht kontinuierlich zwischen den jeweiligen Spannungswerten U₁, U₂ und U₃ eingeschaltet, sondern die Laserstrahlungsquelle 26ₙ wird gepulst betrieben und liefert beispielsweise in konstantem Zeitabstand aufeinanderfolgende Pulse, wobei der Zeitabstand so eng ist, daß die einzelnen Pulse zu einzelnen überlappend positionierten Bildflecken 30ₙ führen.

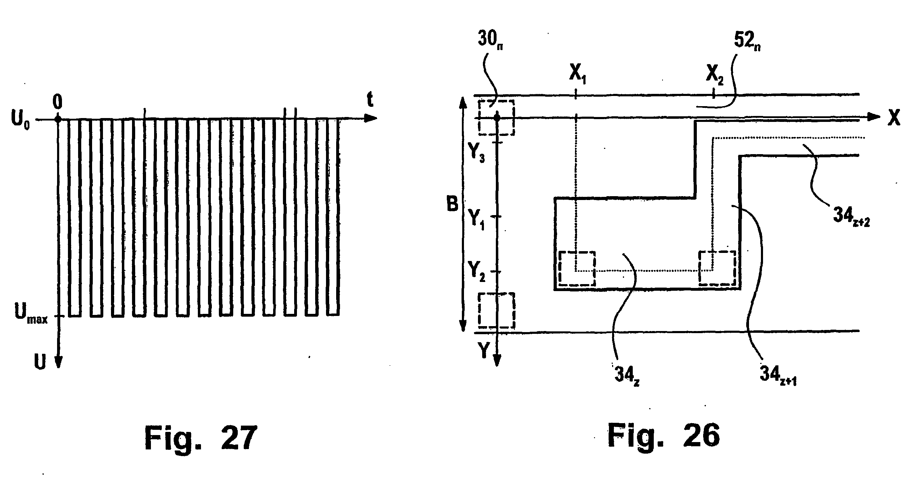

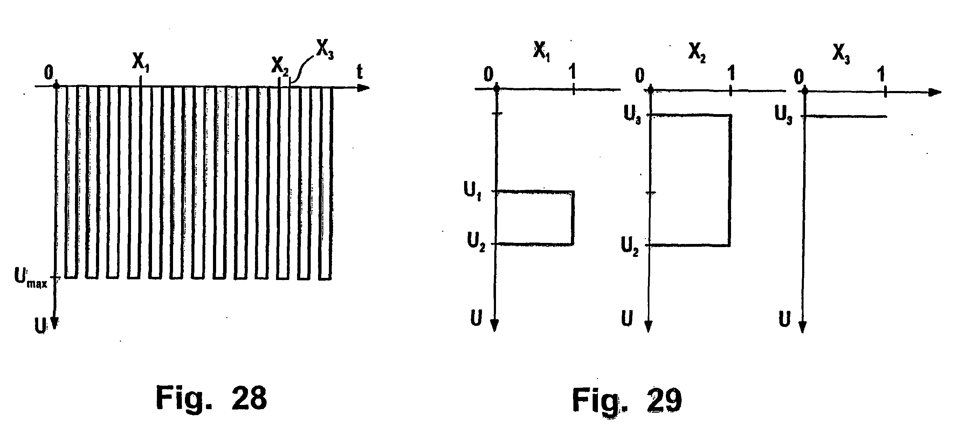

Bei einer fünften Betriebsweise, dargestellt in den Fig. 26, 27, 28 und 29 sollen dieselben Umwandlungsbereiche 34_{z}, 34_{z+1} und 34_{z+2} erzeugt werden, wie beim ersten Ausführungsbeispiel. Hierzu wird jedoch, wie in Fig. 27 dargestellt, die Position des Belichtungsflecks 30ₙ nicht durch Variation der Spannung U eingestellt, sondern die Spannung U variiert periodisch zwischen dem der maximalen Auslenkung in Y-Richtung erforderlichen Spannungswert U_{max.} und dem Spannungswert U₀, so daß beispielsweise zur Speisung der entsprechenden Ablenkeinheit 42ₙ eine Spannungsquelle eingesetzt wird, die eine periodische Funktion erzeugt, die nicht zwingend eine periodische Rechteckfunktion sein muß, sondern auch eine periodische Sinusfunktion oder eine periodische Dreiecksfunktion oder ein periodischer Sägezahn sein kann.

Bei einer derartigen Ansteuerung der Ablenkeinheiten 42ₙ wird nun bei Erreichen der Position X₁ zwischen dem Spannungswert U₁ bis U₂ die Laserstrahlungsquelle 26ₙ eingeschaltet und diese Bedingung bleibt aufrechterhalten bis zum Erreichen der Position X₂, so daß bei der sich stets periodisch ändernden Spannung U und somit der periodischen Bewegung des Belichtungsflecks 30ₙ in Y-Richtung stets zwischen den Positionen Y₁ und Y₂ eine Belichtung zur Erzeugung des Umwandlungsbereichs 34_{z} erfolgt.

Bei Erreichen der Position X₂ wird zwischen der Spannung U₂ und der Spannung U₃ die Laserstrahlungsquelle 26ₙ eingeschaltet gelassen, so daß der Umwandlungsbereich 34_{z+1} erzeugt wird und unmittelbar danach wird lediglich noch bei Erreichen der Spannung U₃ die Laserstrahlungsquelle 26ₙ eingeschaltet, so daß bei den nachfolgenden periodischen Bewegungen des Belichtungsflecks 30ₙ nur bei Erreichen der Position Y₃ eine Belichtung erfolgt.

Diese fünfte Betriebsweise setzt dann voraus, daß die Periodizität, mit welcher der Belichtungsfleck 30ₙ über die gesamte Breite des Streifenbereichs 52ₙ bewegt wird, so ist, daß beim nächstfolgenden Durchlaufen einer bestimmten Y-Position der Belichtungsfleck 30ₙ eine derartige Fläche belichtet, die mit der belichteten Fläche beim vorhergehenden Durchlaufen dieser Y-Position überlappt.

Bei allen Betriebsweisen, bei denen das Positionieren des Belichtungsflecks 30ₙ direkt mit der X-Position des Schlittens 14 gekoppelt ist, kann auch eine Kopplung mit der X-Position indirekt über die Zeitachse t erfolgen, das heißt, daß sich der Schlitten 14 mit konstanter Geschwindigkeit in X-Richtung bewegt und die Steuerung der Position des Belichtungsflecks 30ₙ entsprechend der Zeitachse erfolgt.

## Patentansprüche

1. Lithografiebelichtungseinrichtung zum Herstellen von sich in einer Fläche erstreckenden belichteten Strukturen (36) in einer lichtempfindlichen Schicht (32),
mit einer Aufnahme (14) für die lichtempfindliche Schicht (32),
mit einer Belichtungseinheit (18) umfassend mehrere Laserstrahlungsquellen (26), eine den Laserstrahlungsquellen (26) zugeordnete Fokussierungsoptik (24) für die aus den jeweiligen Laserstrahlungsquellen (26) austretende Laserstrahlung (40), welche aus der Laserstrahlung (40) jeder der Laserstrahlungsquelle (26) einen in der lichtempfindlichen Schicht (32) wirksamen Belichtungsfleck (30) mit einer festgelegten Ausdehnung (A) quer zu einer Belichtungsbewegungsrichtung (50) erzeugt,
mit einer Bewegungseinheit zur Erzeugung einer Relativbewegung zwischen der Fokussierungsoptik (24) und der Aufnahme (14) in der Belichtungsbewegungsrichtung (50) und
mit einer Steuerung (160) zur Steuerung von Intensität und Lage der Belichtungsflecken (30) relativ zur lichtempfindlichen Schicht (32) derart, daß mittels der Belichtungsflecken (30) eine Vielzahl von Umwandlungsbereichen (34) in der lichtempfindlichen Schicht (32) erzeugbar ist, in denen das Material der lichtempfindlichen Schicht (32) von einem Ausgangszustand in den belichteten Zustand umgewandelt ist und die zusammen die belichtete Struktur (36) ergeben,
**dadurch gekennzeichnet , daß** mit dem Belichtungsfleck (30) jeder Laserstrahlungsquelle (26) innerhalb eines sich in der Belichtungsbewegungsrichtung (50) erstreckenden Streifenbereichs (52), welcher quer zu der Belichtungsbewegungsrichtung (50) eine ein Mehrfaches der Ausdehnung (A) des Belichtungsflecks (30) in dieser Richtung (44) betragende Breite (B) aufweist, sämtliche innerhalb desselben liegende Umwandlungsbereiche (34) durch Bewegen des Belichtungsflecks (30) in einer quer zur Belichtungsbewegungsrichtung (50) verlaufenden Ablenkrichtung (44) erzeugbar sind und daß zum Bewegen des Belichtungsflecks (30) in der Ablenkrichtung (44) zwischen den Laserstrahlungsquellen (26) und der Fokussierungsoptik (24) eine steuerbare Ablenkeinrichtung (22) vorgesehen ist.

2. Lithografiebelichtungseinrichtung nach Anspruch 1, **dadurch gekennzeichnet, daß** die Ablenkeinrichtung (22) elektrooptisch arbeitet.

3. Lithografiebelichtungseinrichtung nach Anspruch 1 oder 2, **dadurch gekennzeichnet, daß** die den Laserstrahlungsquellen (26) zugeordneten Streifenbereiche (52) unmittelbar nebeneinander liegen.

4. Lithografiebelichtungseinrichtung nach Anspruch 3, **dadurch gekennzeichnet, daß** die nebeneinander liegenden Streifenbereiche (52) in Richtung quer zur Belichtungsbewegungsrichtung (50) überlappen.

5. Lithografiebelichtungseinrichtung nach einem der voranstehenden Ansprüche, **dadurch gekennzeichnet, daß** Streifenbereiche (52) sich in Belichtungsbewegungsrichtung (50) über die lichtempfindliche Schicht (32) hinwegerstrecken.

6. Lithografiebelichtungseinrichtung nach einem der voranstehenden Ansprüche, **dadurch gekennzeichnet, daß** die Ablenkeinrichtung (22) für die Laserstrahlung jeder Laserstrahlungsquelle (26) eine eigene Ablenkeinheit (42) aufweist, mit welcher die Ablenkung der Laserstrahlung (40) in der Ablenkrichtung (44) zur Positionierung des Belichtungsflecks (30) in Ablenkrichtung (44) innerhalb des diesem entsprechenden Streifenbereichs (52) erfolgt.

7. Lithografiebelichtungseinrichtung nach Anspruch 6, **dadurch gekennzeichnet, daß** mit der Ablenkeinheit (42) der Belichtungsfleck (30) beliebig innerhalb des Streifenbereichs (52) positionierbar ist.

8. Lithografiebelichtungseinrichtung nach Anspruch 6 oder 7, **dadurch gekennzeichnet, daß** jede der Ablenkeinheiten (42) der Ablenkeinrichtung (22) einzeln durch die Steuerung steuerbar ist.

9. Lithografiebelichtungseinrichtung nach einem der Ansprüche 6 bis 8, **dadurch gekennzeichnet, daß** die Ablenkeinheiten (42) in mehreren in der Belichtungsbewegungsrichtung (50) aufeinanderfolgenden Ebenen angeordnet sind.

10. Lithografiebelichtungseinrichtung nach Anspruch 9, **dadurch gekennzeichnet, daß** bei einer Folge von in Ablenkrichtung (44) aufeinanderfolgenden Streifenbereichen (52) die Ablenkeinheiten (42) von in der Folge von Streifenbereichen (52) einander benachbarten Streifenbereichen (52) in unterschiedlichen Ebenen liegen.

11. Lithografiebelichtungseinrichtung nach Anspruch 10, **dadurch gekennzeichnet, daß** bei der Folge von aufeinanderfolgenden Streifenbereichen (52) die Ablenkeinheiten (42) in derselben Ebene liegen, die den Streifenbereichen (52) zugeordnet sind, die in der Folge von Streifenbereichen (52) durch mindestens einen dazwischenliegenden Streifenbereich (52) voneinander getrennt sind.

12. Lithografiebelichtungseinrichtung nach Anspruch 10 oder 11, **dadurch gekennzeichnet, daß** in jeder der in Belichtungsbewegungsrichtung (50) aufeinanderfolgenden Ebenen die Ablenkeinheiten (42) für die Streifenbereiche (52) liegen, die in der Folge der Streifenbereiche (52) um eine der Zahl der Ebenen entsprechende Platzzahl auseinanderliegen.

13. Lithografiebelichtungseinrichtung nach einem der Ansprüche 6 bis 12, **dadurch gekennzeichnet, daß** jede elektrooptische Ablenkeinheit (42) mindestens einen von der Laserstrahlung (40) durchsetzten strahlablenkenden Raumbereich (62) aus elektrooptischem Material aufweist, in welchem die Brechzahl (n₂) gegenüber der Brechzahl (n₁) in dessen Umgebung (64) elektrooptisch variabel ist, und daß bei einer von der Brechzahl (n₁) der Umgebung (64) abweichenden Brechzahl (n₂) in dem mindestens einen Raumbereich (62) die Summe der Raumbereiche (62) der Ablenkeinheit (42) die Laserstrahlung (40) in einer gegenüber einer ursprünglichen Richtung (66) geändert verlaufenden Austrittsrichtung (68, 68') aus der Ablenkeinheit (42) austreten läßt.

14. Lithografiebelichtungseinrichtung nach Anspruch 13, **dadurch gekennzeichnet, daß** der Raumbereich (62) innerhalb einer sich mit ihren Flachseiten (72, 76, 92, 96) parallel zur Ablenkrichtung (44) erstreckenden Wellenleiterplatte (70, 90) aus elektrooptischem Material ausgebildet ist.

15. Lithografiebelichtungseinrichtung nach Anspruch 14, **dadurch gekennzeichnet, daß** die Wellenleiterplatte (70, 90) aus elektrooptischem Material ist und sich über den Raumbereich (62) hinaus erstreckt.

16. Lithografiebelichtungseinrichtung nach einem der Ansprüche 13 bis 15, **dadurch gekennzeichnet, daß** der Raumbereich (62) zwischen einer ersten (74, 94) und einer zweiten Feldelektrode (78, 98) angeordnet ist.

17. Lithografiebelichtungseinrichtung nach Anspruch 16, **dadurch gekennzeichnet, daß** die Feldelektrode (74, 78, 94 ,98) auf gegenüberliegenden Flachseiten (72, 76, 92, 96) einer den Raumbereich (62) umfassenden Wellenleiterplatte (70, 90) angeordnet ist.

18. Lithografiebelichtungseinrichtung nach Anspruch 16 oder 17, **dadurch gekennzeichnet, daß** die erste Feldelektrode (78, 98) durch unmittelbar auf die Flachseite (76, 96) der Wellenleiterplatte (70, 90) aufgebrachtes Elektrodenmaterial gebildet ist.

19. Lithografiebelichtungseinrichtung nach einem der Ansprüche 16 bis 18, **dadurch gekennzeichnet, daß** die zweite Feldelektrode (78, 98) durch unmittelbar auf die zweite Flachseite (76, 96) der Wellenleiterplatte (70, 90) aufgebrachtes Elektrodenmaterial gebildet ist.

20. Lithografiebelichtungseinrichtung nach einem der Ansprüche 13 bis 19, **dadurch gekennzeichnet, daß** eine Form des Raumbereichs (62) durch Festlegung eines räumlichen Verlaufs eines die Wellenleiterplatte (70) durchsetzenden elektrischen Feldes (E) festlegbar ist.

21. Lithografiebelichtungseinrichtung nach Anspruch 20, **dadurch gekennzeichnet, daß** das elektrische Feld (E) durch die Form der ersten Feldelektrode (74) definiert ist.

22. Lithografiebelichtungseinrichtung nach Anspruch 21, **dadurch gekennzeichnet, daß** die zweite Feldelektrode (78) sich über den Raumbereich (62) hinaus erstreckt.

23. Lithografiebelichtungseinrichtung nach einem der Ansprüche 13 bis 22, **dadurch gekennzeichnet, daß** die Form des Raumbereichs (62) durch Festlegung einer räumlichen Form mindestens eines spontanelektrisch polarisierten Domänenbereichs (102, 104) im elektrooptischen Material der Wellenleiterplatte (90) festgelegt ist.

24. Lithografiebelichtungseinrichtung nach Anspruch 23, **dadurch gekennzeichnet, daß** sich die Feldelektroden (94, 98) über den Domänenbereich (102, 104) hinaus erstrecken.

25. Lithografiebelichtungseinrichtung nach einem der Ansprüche 13 bis 24, **dadurch gekennzeichnet, daß** jede Ablenkeinheit (42) mehrere Raumbereiche (62) mit elektrooptisch variabler Brechzahl (n₂) umfaßt.

26. Lithografiebelichtungseinrichtung nach Anspruch 25, **dadurch gekennzeichnet, daß** die mehreren Raumbereiche (62) in Ausbreitungsrichtung der jeweiligen Laserstrahlung (40) aufeinanderfolgend angeordnet sind.

27. Lithografiebelichtungseinrichtung nach Anspruch 25 oder 26, **dadurch gekennzeichnet, daß** die mehreren Raumbereiche (62) in derselben Wellenleiterplatte (70, 90) angeordnet sind.

28. Lithografiebelichtungseinrichtung nach einem der Ansprüche 25 bis 27, **dadurch gekennzeichnet, daß** jede Ablenkeinheit (42) die Laserstrahlung (40) durch zwei entgegengesetzt wirkende Raumbereiche (62, 62') in Ablenkrichtung (44) im wesentlichen parallel versetzt.

29. Lithografiebelichtungseinrichtung nach einem der Ansprüche 13 bis 28, **dadurch gekennzeichnet, daß** sich der mindestens eine strahlablenkende Raumbereich (62) in Ablenkrichtung (44) keilähnlich erweitert oder verjüngt und von der gesamten Laserstrahlung (40) durchsetzt ist.

30. Lithografiebelichtungseinrichtung nach Anspruch 29, **dadurch gekennzeichnet, daß** der Raumbereich ähnlich einem Prismenbereich (62) ausgebildet ist.

31. Lithografiebelichtungseinrichtung nach einem der voranstehenden Ansprüche, **dadurch gekennzeichnet, daß** sich die Laserstrahlung (40) in der Wellenleiterplatte (70, 90) in Ablenkrichtung (44) aufgeweitet ausbreitet.

32. Lithografiebelichtungseinrichtung nach Anspruch 31, **dadurch gekennzeichnet, daß** die Laserstrahlung (40) durch eine Strahlformungseinheit (46) parallel zur Ablenkrichtung (44) aufgeweitet wird.

33. Lithografiebelichtungseinrichtung nach Anspruch 32, **dadurch gekennzeichnet, daß** die Strahlformungseinheit (46) in die Wellenleiterplatte (70, 90) integriert ist.

34. Lithografiebelichtungseinrichtung nach Anspruch 32 oder 33, **dadurch gekennzeichnet, daß** die Strahlformungseinheit (46) elektrooptisch arbeitet.

35. Lithografiebelichtungseinrichtung nach Anspruch 32 oder 33, **dadurch gekennzeichnet, daß** die Strahlformungseinheit (46') als GRIN-Linse ausgebildet ist.

36. Lithografiebelichtungseinrichtung nach einem der voranstehenden Ansprüche, **dadurch gekennzeichnet, daß** die Steuerung jede der Ablenkeinheiten (42) mit einer der erforderlichen Position des jeweiligen Belichtungsflecks (30) innerhalb des jeweiligen Streifenbereichs (52) entsprechenden Spannung ansteuert.

37. Lithografiebelichtungseinrichtung nach Anspruch 36, **dadurch gekennzeichnet, daß** die Spannung stufenlos variabel ist.

38. Lithografiebelichtungseinrichtung nach Anspruch 36, **dadurch gekennzeichnet, daß** die Spannung in diskreten Schritten variabel ist.

39. Lithografiebelichtungseinrichtung nach einem der voranstehenden Ansprüche, **dadurch gekennzeichnet, daß** in den mehreren Raumbereichen (62) einer Ablenkeinheit (42) die Brechzahl (n₂) synchron variierbar ist.

40. Lithografiebelichtungseinrichtung nach einem der Ansprüche 1 bis 38, **dadurch gekennzeichnet, daß** bei den mehreren Raumbereichen (62) einer Ablenkeinheit (42) die Brechzahl (n₂) einzeln ansteuerbar ist.

41. Lithografiebelichtungseinrichtung nach Anspruch 40, **dadurch gekennzeichnet, daß** die einzelnen Raumbereiche (62) entweder spannungsfrei oder mit einem festgelegten Spannungswert angesteuert sind.

42. Lithografiebelichtungseinrichtung nach einem der voranstehenden Ansprüche, **dadurch gekennzeichnet, daß** die Steuerung (160) die Ablenkeinheit (42) mit einer der erforderlichen Position (Y) des Belichtungsflecks (30) innerhalb des jeweiligen Streifenbereichs (52) entsprechenden Spannung (U) steuert.

43. Lithografiebelichtungseinrichtung nach Anspruch 42, **dadurch gekennzeichnet, daß** mit der Steuerung (160) die Spannung (U) stufenlos variierbar ist.

44. Lithografiebelichtungseinrichtung nach Anspruch 42, **dadurch gekennzeichnet, daß** mit der Steuerung (160) die Spannung (U) in diskreten Schritten variierbar ist.

45. Lithografiebelichtungseinrichtung nach einem der Ansprüche 42 bis 44, **dadurch gekennzeichnet, daß** mit der Steuerung (160) bei mehreren Raumbereichen (62) einer Ablenkeinheit (42) die Elektroden (74a bis 74d) synchron ansteuerbar sind.

46. Lithografiebelichtungseinrichtung nach Anspruch 44, **dadurch gekennzeichnet, daß** mit der Steuerung (160) bei mehreren Raumbereichen (62) einer Ablenkeinheit (42) die den einzelnen Raumbereichen (62) zugeordneten Elektroden (74a bis 74d) einzeln ansteuerbar sind.

47. Lithografiebelichtungseinrichtung nach einem der voranstehenden Ansprüche, **dadurch gekennzeichnet, daß** die Steuerung (160) im Verlauf der Bewegung des Belichtungsflecks (30) in der Belichtungsbewegungsrichtung (50) und in der Ablenkrichtung (44) den Belichtungsfleck (30) innerhalb des Streifenbereichs (52) positioniert und dann, wenn der Belichtungsfleck (30) innerhalb eines Umwandlungsbereichs (34) liegt, durch Intensitätssteuerung der Laserstrahlungsquelle (26) in diesem Belichtungsfleck (30) belichtet wird.

48. Lithografiebelichtungseinrichtung nach Anspruch 47, **dadurch gekennzeichnet, daß** die Steuerung (160) so lange kontinuierlich belichtet, solange der Belichtungsfleck (30) in einem Umwandlungsbereich (34) liegt.

49. Lithografiebelichtungseinrichtung nach Anspruch 47, **dadurch gekennzeichnet, daß** die Steuerung (160) so lange gepulst belichtet, solange der Belichtungsfleck (30) im Umwandlungsbereich (34) liegt.

50. Lithografiebelichtungseinrichtung nach einem der Ansprüche 1 bis 46, **dadurch gekennzeichnet, daß** von der Steuerung (160) der Belichtungsfleck (30) entsprechend einer periodischen Funktion in dem Streifenbereich (52) ständig zwischen einer Minimal- und einer Maximalstellung hin- und herbewegt wird und dann, wenn der Belichtungsfleck (30) seine Position in Ablenkrichtung (44) erreicht hat, durch Intensitätssteuerung der Laserstrahlungsquelle (26) eine Belichtung erfolgt.
